# FASCICULE DE BREVET EUROPEEN

(11) **EP 2 475 618 B1**
(45) Date de publication et mention de la délivrance du brevet: **04.09.2013**
(21) Numéro de dépôt: 10768993.7
(22) Date de dépôt: 08.09.2010
(51) Int. Cl.: C01G 19/00, C01G 21/00, C01G 23/00, C01G 25/00, C01B 17/20, C01B 19/00, B01J 27/04, H01L 31/0328

(54) **MATÉRIAU SOLIDE À L'ÉTAT DIVISÉ, PROCÉDÉ DE FABRICATION D'UN TEL MATÉRIAU ET UTILISATION D'UN TEL MATÉRIAU DANS UNE CELLULE PHOTOVOLTAÏQUE**
FESTSTOFFMATERIAL IN GETEILTEM ZUSTAND, VERFAHREN ZUR HERSTELLUNG EINES DERARTIGEN MATERIALS UND VERWENDUNG EINES DERARTIGEN MATERIALS FÜR EINE SOLARZELLE
SOLID MATERIAL IN DIVIDED STATE, METHOD FOR MANUFACTURING SUCH A MATERIAL AND USE OF SUCH A MATERIAL IN A PHOTOVOLTAIC CELL

(30) Priorité: 10.09.2009 FR 0904322
(43) Date de publication de la demande: 18.07.2012
(73) Titulaire: Universite Paul Sabatier Toulouse III, 31062 Toulouse Cedex 9 (FR); Centre National de la Recherche Scientifique (C.N.R.S.), 75016 Paris (FR); Institut National des Sciences Appliquées de Toulouse, 31077 Toulouse Cedex 4 (FR); Ecole Superieure Des Beaux-arts De La Reunion, 97826 Le Port Cedex (RE)
(72) Inventeur: CHANE-CHING, Jean-Yves, F-31650 Saint Orens de Gameville (FR); GILLORIN, Arnaud, F-78200 Magnanville (FR); MARIE, Xavier, F-31320 Pechabou (FR); DUFOUR, Pascal, F-31860 Villate (FR); ZABERCA, Oana, F-31200 Toulouse (FR)
(74) Mandataire: Cabinet BARRE LAFORGUE & associés
(86) Numéro de dépôt international: PCT/FR2010/051866
(87) Numéro de publication internationale: WO 2011/030055

(56) Documents cités:
- WO-A2-2009/137637
- TODOROV T ET AL: "Cu2ZnSnS4 films deposited by a soft-chemistry method" THIN SOLID FILMS, ELSEVIER-SEQUOIA S.A. LAUSANNE, CH, vol. 517, no. 7, 2 février 2009 (2009-02-02), pages 2541-2544, XP025928679 ISSN: 0040-6090 [extrait le 2008-11-08] cité dans la demande
- TANAKA ET AL: "Preparation of Cu2ZnSnS4 thin films by sulfurizing sol-gel deposited precursors" SOLAR ENERGY MATERIALS AND SOLAR CELLS, ELSEVIER SCIENCE PUBLISHERS, AMSTERDAM, NL, vol. 91, no. 13, 5 juin 2007 (2007-06-05), pages 1199-1201, XP022104549 ISSN: 0927-0248
- Q.GUO ET AL.: "Synthesis of CuZnSnS4 nanocrystal ink and its use in solar cells" JOURNAL OF THE AMERICAN CHEMICAL SOCIETY, vol. 131, 31 juillet 2009 (2009-07-31), pages 11672-11673, XP002566027 cité dans la demande
- C. STEINHAGEN ET AL: "Synthesis of Cu2ZnSnS4 nanocrystals for use in low cost photovoltaics" JOURNAL OF THE AMERICAN CHEMICAL SOCIETY, vol. 131, 17 août 2009 (2009-08-17), pages 12554-12555, XP002566028 cité dans la demande
- S.C, RIHA ET AL.: "Solution based synthesis and characterization of Cu2ZnSnS4 nanocrystals" JOURNAL OF THE AMERICAN CHEMICAL SOCIETY, vol. 131, 12 août 2009 (2009-08-12), pages 12054-12055, XP002566029

## Description

L'invention concerne un matériau solide à l'état divisé comprenant une structure de chalcogénure métallique, un procédé de fabrication d'un tel matériau solide et une dispersion d'un tel matériau solide dans un liquide -notamment un liquide polaire-. L'invention concerne aussi l'utilisation d'une telle dispersion pour la fabrication d'un film photoélectrique, un procédé de fabrication d'un tel film photoélectrique et une cellule photovoltaïque comprenant un tel film photoélectrique.

Un tel matériau solide trouve des applications dans le domaine de la valorisation des énergies propres et renouvelables -notamment de l'énergie solaire- pour la fabrication d'un film photoélectrique de faible épaisseur d'une cellule photovoltaïque de conversion photoélectrique.

Un tel matériau solide peut aussi être utilisé pour la fabrication d'un matériau catalyseur photoactif, en particulier adapté pour la décomposition par photocatalyse de préparations organiques polluantes et/ou pour la décomposition de l'eau par photo-catalyse en vue de la production d'hydrogène.

On connaît déjà différents procédés et matériaux utilisés pour la fabrication de films minces photoélectriques. Dans un premier type de solution technique connue, un film photosensible est formé d'une couche de silicium (*cf.* par exemple «Martinuzzi S., Reflets de la physique, décembre 2007, 9-13»). Une telle solution nécessite la fabrication de silicium solide par réduction de silice, la purification du silicium solide et l'usinage de couches minces de silicium à partir de silicium solide purifié. Une telle fabrication présente un coût, notamment énergétique, élevé qui limite aujourd'hui le développement à très grande échelle des cellules solaires au silicium. En raison de son coût énergétique, un tel procédé de fabrication ne préserve pas l'environnement.

FR 2 922 046 décrit un deuxième type de solution connue dans laquelle une couche d'agent photo-absorbant est formée d'un matériau semiconducteur comprenant du cuivre, de l'indium, du sélénium et alternativement du gallium. Une telle couche continue d'agent absorbant comprend nécessairement de l'indium qui est une ressource d'origine naturelle et qui est susceptible de s'épuiser. En outre, une telle couche continue d'agent photo-absorbant est obtenue par dépôt de matière en phase vapeur sous pression réduite ou par électrodéposition. Un tel procédé d'obtention d'un film d'agent absorbant nécessite des installations complexes adaptées pour le dépôt de matière à l'échelle atomique.

Katagiri (*cf.*Katagiri et al., (2008), Applied Physics Express, 1, 041201*)* propose la formation d'un film Cu₂ZnSnS₄ par pulvérisation radiofréquence à partir de cibles Cu, SnS et ZnS. Un tel film présente un rendement de conversion de l'énergie solaire en énergie électrique de l'ordre de 6.7% et ne permet pas la réalisation à l'échelle industrielle de capteurs photovoltaïque rentables du point de vue énergétique.

Todorov (*cf.* Todorov et al., (2009), Thin Solid films, 517, 2451-2544) décrit la fabrication d'un film Cu₂ZnSnS₄ à partir de nanoparticules de structure amorphe. Un tel matériau amorphe ne permet pas de contrôler le retrait lors de la densification par frittage de ce matériau amorphe et la formation d'un film nanostructuré.

Steinhagen (*cf.*Steinhagen et al., (2009), J. Am. Chem. Soc., 131, 12554-12555) décrit des particules de Cu₂ZnSnS₄ de très petite taille -de l'ordre de 10 nm- obtenues par précipitation contrôlée dans l'oléylamine. Un tel procédé, qui nécessite l'élimination de l'oléylamine par lavage, n'est pas respectueux de l'environnement et ne permet pas d'obtenir des particules de taille supérieure à 10 nm. De telles particules ne sont en outre pas exemptes de surfactant et ne présentent pas de domaine cristallin de grande taille. En outre, de telles particules ne permettent pas la formation d'un film de particules présentant une densité crue élevée adaptée pour permettre la formation par frittage d'un film photoélectrique de qualité photovoltaïque.

On connaît aussi de Guo (*cf.* Guo et al., (2009), Journal of American Chemical Society, 131, 11672-11673*)* une encre nanocristalline de Cu₂ZnSnS₄ pour cellule solaire. De tels cristaux sont synthétisés dans l'oléylamine et forment une dispersion stable dans un solvant apolaire -notamment dans le toluène-. Ils ne permettent pas de former une suspension stable de tels nano-cristaux dans un solvant liquide polaire.

L'invention vise à pallier les inconvénients précédemment évoqués en fournissant un matériau solide, de grande pureté pouvant être utilisé pour la fabrication d'un film photo-absorbant de faible épaisseur mais présentant un rendement de conversion photovoltaïque élevé.

En particulier, l'invention vise un tel matériau solide permettant la formation d'un film structuré à l'échelle submicronique et à l'échelle nanométrique.

L'invention vise aussi un matériau solide adapté pour permettre la formation d'une couche de particules de taille submicronique présentant une densité crue élevée adaptée pour permettre la formation d'un film photoélectrique par frittage de ladite couche.

L'invention vise aussi un tel matériau solide de cristallinité élevée et qui soit sensiblement exempt de composés hydrocarbonés de type amphiphile tensioactif (surfactant).

En particulier, l'invention vise un tel matériau solide qui ne nécessite pas, pour son obtention, l'utilisation d'un composé amphiphile hydrocarboné, notamment d'un composé tensioactif, en particulier d'une amine grasse du type oléylamine. L'invention vise donc un tel matériau solide adapté pour pouvoir être dispersé dans les solvants liquides polaires.

L'invention vise également à atteindre tous ces objectifs à moindre coût, en proposant un tel matériau solide de faible coût de fabrication réalisé à partir de composants chimiques, usuels et/ou peu onéreux.

L'invention vise également à proposer un procédé de fabrication d'un tel matériau solide qui soit compatible avec les contraintes de production, de rentabilité et de sécurité à l'échelle industrielle.

L'invention vise aussi un tel procédé qui ne nécessite pas l'utilisation de composés inhibiteurs de la croissance de particules, en particulier de composés amphiphiles tensioactifs (surfactants).

L'invention vise également à proposer un tel procédé qui ne produise que peu de déchets, qui soit respectueux de l'environnement et qui satisfasse aux critères du développement durable.

L'invention vise de surcroît un tel procédé préservant les habitudes de travail des personnels, qui soit facile à utiliser, et qui n'implique que peu de manipulations.

L'invention vise aussi l'utilisation d'un tel matériau solide pour la fabrication d'un film photoélectrique nanostructuré sensiblement exempt de défauts de structure susceptibles de former des pièges à électrons.

L'invention vise aussi une dispersion d'un tel matériau solide dans un milieu liquide pouvant être appliquée par enduction sur la surface d'un support de façon à permettre la formation d'une couche mince semi-conductrice dudit matériau solide sans nécessiter ni procédé de dépôt sous vide -notamment par pulvérisation sous pression réduite- ni électrodéposition.

L'invention vise en outre une telle dispersion qui soit stable dans le temps -notamment vis-à-vis de la décantation-.

L'invention vise en particulier une dispersion d'un tel matériau solide à l'état divisé dans un milieu liquide polaire.

L'invention vise également l'utilisation d'une telle dispersion pour la fabrication d'un film mince appliqué sur la surface d'un support, en particulier d'un support de forme complexe -notamment un support non plan-.

L'invention vise en particulier l'utilisation d'une telle dispersion pour la fabrication d'un film photoélectrique, notamment un film photoélectrique d'une cellule photovoltaïque.

L'invention vise aussi en particulier l'utilisation d'une telle dispersion pour la fabrication d'un film photoélectrique d'un matériau photo-catalytique.

Pour ce faire, l'invention concerne un matériau solide de formule (A) suivante :
(Cu⁺¹*ₐ₋ᵤ*; Ag⁺¹*ᵤ*; Zn⁺²_{*b-v-*(*y*/*2*)}; Cd⁺²*ᵥ;* Sn⁺⁴_{*c-w*-(*y*/*2*)}; *¹X⁺⁴_{w};* ;*²X⁺³_{y}*; S⁻²*_{d-x}*; Se⁻²*ₓ*) (A), où; *a, b, c, d, u, v, w, x* et y et leur combinaisons arithmétiques sont des nombres réels qui représentent la proportion molaire de chaque élément auquel chaque nombre est associé dans la formule (A) -notamment choisis de façon à satisfaire l'électroneutralité du matériau-, et tels que:
   ○ 1,6<*a*<2,4;
   ○ 0,6 < *b* < 1,2;
   ○ 0,6<*c*<1,2;
   ○ 3,5<*d*<4,5, et;
   o *u*, *v*, *w*, *x* et *y* appartiennent indépendamment les uns des autres à l'ensemble des nombre réels appartenant à l'intervalle [0;0,5[, et,
      ■ *¹X⁺⁴* est choisi dans le groupe formé des cations du titane (Ti), des cations du zirconium (Zr) et des cations du plomb (Pb),
      ■ *²X⁺³* est choisi dans le groupe formé des cations du gallium (Ga), des cations de l'indium (In) et des cations de l'yttrium (Y),
ledit matériau solide :
   - est à l'état divisé sous la forme de particules présentant un diamètre équivalent moyen compris 15 nm et 400 nm, et,
   - présente, par analyse dudit matériau solide par diffraction des rayons X, une structure cristalline unique, et ;
   - est adapté pour pouvoir former une dispersion stable d'au moins un matériau solide de formule (A) dans un liquide, dit liquide de dispersion, formé d'au moins un composé présentant une valeur de δₚ supérieure à 8 -en particulier une valeur de δₚ comprise entre 8 et 20- et une valeur de δ_{H} supérieure à 5 -en particulier une valeur de δ_{H} comprise entre 5 et 40-.

Dans toute la suite, l'expression « diamètre équivalent » d'une particule désigne le diamètre du cercle de même aire que la projection orthogonale de ladite particule sur un plan fictif tangent à ladite particule. En particulier, le « diamètre équivalent moyen » des particules d'une composition de particules peut être évalué par des moyens connus en eux-mêmes notamment par micrographie électronique à transmission ou par micrographie électronique à haute résolution. On détermine le diamètre équivalent moyen des particules d'une composition de particules à partir de la mesure du diamètre d'au moins 50 particules visualisées sur des clichés de microscopie électronique à transmission, par exemple à un facteur de grossissement compris entre 60 000 et 200 000. La valeur médiane de l'histogramme de distribution des tailles des particules mesurées est le diamètre équivalent moyen des particules de la composition de particules.

De telles valeurs de δₚ et de δ_{H} sont des valeurs connues de l'homme du métier et sont décrites par exemple dans l'ouvrage «Handbook of solubility parameters and other cohesive parameters, 1983, CRC press, p153-157». En particulier, δₚ et δ_{H} sont des paramètres de solubilité définis par Hidelbrandt, le paramètre δₚ étant associé à une force d'interaction polaire et le paramètre δ_{H} étant associé à une force d'interaction hydrogène.

Avantageusement, le liquide de dispersion est formé d'un composé présentant une valeur de δₚ supérieure à 8 -en particulier une valeur de δₚ comprise entre 8 et 20- et une valeur de δ_{H} supérieure à 5 -en particulier une valeur de δ_{H} comprise entre 5 et 40-.

Avantageusement, le liquide de dispersion est formé d'au moins un composé dont la somme (δₚ + δ_{H}) est supérieure à 22. En particulier, le liquide de dispersion est formé d'un composé unique dont la somme (δₚ + δ_{H}) est supérieure à 22.

Avantageusement, le matériau solide de formule (A) est adapté pour pouvoir former une dispersion stable dans un liquide, dit liquide de dispersion, formé d'au moins un composé solvant polaire.

Avantageusement, on choisit le liquide de dispersion dans le groupe formé des solvants développant de fortes interactions polaires (δₚ) et de fortes interactions hydrogènes (δ_{H}).

Dans un tel matériau solide de formule (A) à l'état divisé, les particules présentent une distribution statistique de taille dans laquelle moins de 10% des particules présentent une taille supérieure à deux fois la valeur médiane de la distribution en taille et moins de 10% des particules présentent une taille inférieure à la moitié de la valeur médiane de la distribution en taille. Dans la suite, le terme de particule désigne une entité solide individualisée. Une telle particule peut être sous la forme d'une cristallite élémentaire unique formant une particule individualisée ou bien sous la forme d'une pluralité de cristallites associées par agrégation au sein de ladite particule individualisée. En tout état de cause, la pluralité de cristallites présente une structure unique par diffraction des rayons X.

L'analyse par diffraction des Rayons X de la structure d'un matériau solide de formule (A) selon l'invention montre un diagramme de diffraction des Rayons X conforme au diagramme de la Kesterite (Cu₂ZnSnS₄, JCPDS n°00-026-0575 référencée au *« Joint Committee on Powder Diffraction Standards* ». En particulier, le diagramme de diffraction des rayons X d'un matériau solide de formule (A) selon l'invention ne présente pas de raie attribuable à des structures du type Cu₂S (Chalcosine, JCPDS n°01-072-2276), CuS (Coveline, JCPDS n°01-076-1725), SnS (sulfure d'étain, JCPDS n°00-040-1465), Cu₃SnS₄ (Pétrukite, JCPDS n°00-036-0217), ZnS (Wurtzite, JCPDS n°00-036-1450, JCPDS n°01-072-0163, JCPDS n°01-075-1534), Cu₉S₈ (Yarrowitte, JCPDS n°00-036-0379).

Dans un matériau solide selon l'invention, la formule (A) décrit la composition chimique du motif élémentaire formant la structure cristalline unique dudit matériau solide. Une telle composition chimique peut être déterminée par analyse chimique selon des moyens connus en eux-mêmes de l'homme du métier.

Selon un mode particulier de réalisation de l'invention, les particules d'un matériau solide de formule (A) selon l'invention sont des particules de forme globalement isotropes (sans direction d'allongement privilégiée) dont le diamètre équivalent moyen compris entre 15 nm et 400 nm.

En particulier, les particules d'un matériau solide de formule (A) selon l'invention présentent, dans un repère spatial orthonormé, trois dimensions orthogonales du même ordre de grandeur.

Avantageusement et selon l'invention, les particules constitutives du matériau solide de formule (A) présentent un diamètre équivalent moyen compris entre 15 nm et 400 nm, notamment compris entre 25 nm et 300 nm. Le diamètre équivalent moyen des particules peut être compris entre 15 nm et 300 nm, notamment entre 15 et 100 nm, de préférence compris entre 25 nm et 100 nm.

Avantageusement et selon l'invention, on choisit les éléments constitutifs du matériau solide de formule (A) de façon que, à leur degré d'oxydation dans le matériau solide de formule (A), chacun de ces éléments présente une répartition électronique dans laquelle la couche d externe est soit une couche d externe vide soit une couche d externe pleine, c'est-à-dire présentant 10 électrons.

Les cations Cd⁺², *¹X⁺⁴* et *²X⁺³* sont des cations d'éléments dopants du matériau solide de formule (A), adaptés pour ne pas permettre une transition électronique entre deux orbitales d desdits cations Cd⁺², *¹X⁺⁴* et *²X⁺³*.

Les cations Cd⁺², *¹X⁺⁴* et *²X*^{*+*3} sont choisis de façon que, au degré d'oxydation de chacun des cations Cd⁺², *¹X⁺⁴* et *²X⁺³* dans le matériau solide de formule (A), la répartition électronique de chaque cation Cd⁺², *¹X⁺⁴* et *²X⁺³* présente soit une couche d -notamment les couches 3d, 4d et 5d- externe vide soit une couche externe pleine, c'est-à-dire présentant 10 électrons.

Avantageusement et selon l'invention, les particules sont constituées exclusivement du matériau solide de formule (A). En particulier, les particules constituant le matériau solide de formule (A) selon l'invention sont exemptes de composé hydrocarboné tensioactif, en particulier exemptes d'amines grasses -notamment d'oléylamine- et d'acides gras -notamment d'acides carboxyliques, d'acides sulfoniques et autres-.

En particulier, les particules constituées du matériau solide de formule (A) selon l'invention forment une dispersion stable dans les solvants polaires. En fait, une telle dispersion stable dudit matériau solide de formule (A) dans le liquide de dispersion est adaptée pour que plus de 70%, notamment plus de 80%, préférentiellement plus de 90% en poids du matériau solide de formule (A) restent en suspension dans le liquide de dispersion après une période d'une durée de 2 h -de préférence d'une durée de 6 h- sans agitation de ladite dispersion. De telles particules selon l'invention ne forment pas d'agrégats -tendant à minimiser la surface des particules exposée au liquide de dispersion- dès lors qu'elles sont placées dans un milieu de dispersion polaire, et ne sédimentent donc pas sur cette période d'une durée de 2 h -notamment d'une durée de 6 h-.

En particulier, une telle dispersion stable dudit matériau solide de formule (A) dans le liquide de dispersion est adaptée pour que plus de 70%, notamment plus de 80%, préférentiellement plus de 90% en poids du matériau solide de formule (A) restent en suspension dans le liquide de dispersion après une période d'une durée de 48 h (2 jours) -préférentiellement d'une durée de 96 h (4 jours)- sans agitation de ladite dispersion.

Les inventeurs ont observé que les particules d'un matériau solide de formule (A) selon l'invention forment une suspension stable dans les solvants polaires alors que les particules de l'état de la technique se dispersent dans des solvants apolaires -notamment dans le toluène- montrant que les nano-cristaux de l'état de la technique présentent une couche de surface de nature hydrophobe et apolaire enrobant lesdits nano-cristaux.

Avantageusement et selon l'invention, le liquide de dispersion est formé d'au moins un composé choisi dans le groupe formé de l'alcool éthylique (δₚ = 8,8, δ_{H} = 19,4), de l'acétonitrile (δₚ = 18, δ_{H} = 6,1), de l'éthylène glycol (δₚ = 11, δ_{H} =26), du diméthylsulfoxyde (δₚ = 16,4, δ_{H} = 10,2), du propylène glycol (δₚ =9, δ_{H} =22), du méthanol (δₚ = 13, δ_{H} = 21) et du diméthylformamide (δₚ = 14, δ_{H} =11).

Avantageusement, le liquide de dispersion est formé d'un composé choisi dans le groupe formé de l'alcool éthylique (δₚ = 8,8, δ_{H} =19,4), de l'acétonitrile (δₚ = 18, δ_{H} = 6,1), de l'éthylène glycol (δₚ = 11, δ_{H} = 26), du diméthylsulfoxyde (δₚ = 16,4, δ_{H} = 10,2), du propylène glycol (δₚ = 9, δ_{H} = 22), du méthanol (δₚ = 13, δ_{H} = 21) et du diméthylformamide (δₚ = 14, δ_{H} = 11).

Avantageusement, le liquide de dispersion est formé en mélange d'une pluralité de composés choisis dans le groupe formé de l'alcool éthylique (δₚ = 8,8, δ_{H} = 19,4), de l'acétonitrile (δₚ = 18, δ_{H} = 6,1), de l'éthylène glycol (δₚ = 11, δ_{H} = 26), du diméthylsulfoxyde (δₚ = 16,4, δ_{H} = 10,2), du propylène glycol (δₚ = 9, δ_{H} = 22), du méthanol (δₚ = 13, δ_{H} = 21) et du diméthylformamide (δₚ = 14, δ_{H} = 11).

Avantageusement, on choisit le liquide de dispersion dans le groupe formé des solvants développant de fortes interactions polaires (δₚ) et de fortes interactions hydrogènes (δ_{H}). Ainsi on choisit plus particulièrement au moins un solvant dans le groupe formé de l'alcool éthylique (δₚ = 8,8, δ_{H} = 19,4), de l'acétonitrile (δₚ, = 18, δ_{H} = 6,1), de l'éthylène glycol (δₚ, = 11, δ_{H} = 26) et du diméthylsulfoxyde (δₚ = 16,4, δ_{H} = 10,2).

Avantageusement, le liquide de dispersion est un liquide de grande pureté et de faible force ionique.

Avantageusement, les particules du matériau solide de formule (A) selon l'invention dispersée dans le liquide de dispersion sont des particules chargées en surface. Cette charge de surface est déterminée de façon connue de l'homme du métier par des mesures de mobilité électrophorétique. En particulier, le liquide de dispersion de faible force ionique est adapté pour ne pas produire une constante d'écran vis-à-vis des charges des particules.

Avantageusement et selon l'invention, le matériau solide de formule (A) présente, en spectroscopie d'absorption, une largeur de bande interdite comprise entre 0,9 eV et 2,8 eV, notamment comprise entre 1,0 eV et 1,8 eV, préférentiellement entre 1,3 eV et 1,6 eV. Avantageusement, le matériau solide de formule (A) présente, en spectroscopie d'absorption, une largeur de bande interdite sensiblement de l'ordre de 1,5 eV.

On détermine la largeur de bande interdite d'un tel matériau solide de formule (A) par spectroscopie d'absorption au moyen d'un spectromètre d'absorption UV-VIS-NIR, c'est-à-dire couvrant les domaines de longueurs d'onde de l'ultraviolet, du visible et du proche infrarouge. On détermine de manière expérimentale la valeur de l'énergie correspondant à la bande interdite selon la méthode décrite, par exemple, dans *«* Material Research Bulletin, (2008), 43, 2742-2750 ». Pour ce faire, on trace la variation de l'absorbance de la dispersion de particules à partir de laquelle on détermine la valeur du coefficient α d'absorption. On trace la courbe (α.h.υ)² en fonction de l'énergie (h.υ), où;
- h est la constante de Planck,
- α est le coefficient d'absorption,
- υ est la fréquence de la radiation incidente,
on trace la droite D tangente à la courbe (α.h.υ) en fonction de l'énergie (h.υ) vers les hautes énergies. La droite D coupe l'axe des abscisses (énergie) à la valeur (Eg) de l'énergie correspondant à la bande interdite.

Avantageusement, on détermine la largeur de bande interdite d'un tel matériau solide de formule (A) sur un film de particules obtenu par évaporation à température ambiante du liquide de dispersion d'une dispersion de particules selon l'invention sur un substrat de verre.

Avantageusement, la largeur de bande interdite mesurée pour des particules d'un matériau solide de formule (A) dont le diamètre est compris entre 15 nm et 400 nm est comprise entre 0,9 eV et 2,8 eV. Avantageusement la largeur de bande interdite mesurée pour des particules d'un matériau solide de formule (A) dont le diamètre est compris entre 25 nm et 300 nm est comprise entre 1,0 eV et 1,8 eV. Avantageusement la largeur de bande interdite mesurée pour des particules d'un matériau solide de formule (A) dont le diamètre est compris entre 25 nm et 100 nm et présentant un domaine cristallin unique (particules monocristallines) de taille sensiblement de l'ordre de grandeur de celle du diamètre équivalent moyen de la particule est comprise entre 1,3 eV et 1,6 eV.

Avantageusement et selon l'invention, les particules constitutives du matériau solide de formule (A) présentent au moins un domaine, dit domaine cristallin, de taille moyenne, mesurée par diffraction des rayons X, comprise entre 4 nm et 100 nm -notamment comprise entre 5 nm et 80 nm-, ledit domaine cristallin présentant la structure cristalline unique. La taille moyenne du(des) domaine(s) cristallin(s) des particules formant le matériau solide de formule (A) selon l'invention est déterminée par l'homme du métier par des moyens d'analyse de la diffraction des rayons X (DRX) connus en soi, notamment par application de la formule de Debye et Scherrer.

Avantageusement et selon l'invention, le matériau solide de formule (A) présente, par spectroscopie Raman, une raie de diffusion, dite raie primaire, présentant une intensité maximum de diffusion à une valeur de nombre d'onde comprise entre 310 cm⁻¹ et 340 cm⁻¹ -notamment comprise entre 330 cm⁻¹ et 340 cm⁻¹ -en particulier sensiblement de l'ordre de 336 cm⁻¹-

Avantageusement et selon l'invention, la raie primaire présente une largeur de raie à mi-hauteur comprise entre 5 cm⁻¹ et 60 cm⁻¹ -notamment comprise entre 10 cm⁻¹ et 60 cm⁻¹-.

Avantageusement dans une première variante d'un matériau selon l'invention, le matériau solide de formule (A) est formé de particules poly-cristallines. Dans de telles particules poly-cristallines, le diamètre équivalent moyen du(des) domaine(s) cristallin(s) des particules constitutives du matériau solide de formule (A), mesuré par diffraction des rayons X, est inférieur au diamètre équivalent moyen desdites particules.

Dans cette première variante, avantageusement et selon l'invention, le matériau solide de formule (A) est formé de particules présentant un diamètre équivalent moyen compris entre 15 nm et 400 nm et dont la taille moyenne du domaine cristallin est comprise entre 4 nm et 20 nm.

Avantageusement, dans cette première variante d'un matériau selon l'invention, le matériau solide de formule (A) présente, par spectroscopie Raman, une raie de diffusion, dite raie primaire, présentant une intensité maximum de diffusion à une valeur de nombre d'onde comprise entre 330 cm⁻¹ et 340 cm⁻¹-notamment sensiblement de l'ordre de 336 cm⁻¹- et une largeur de raie à mi-hauteur comprise entre 10 cm⁻¹ et 60 cm⁻¹.

Avantageusement et selon une deuxième variante de l'invention, le matériau solide de formule (A) est formé de particules poly-cristallines présentant un diamètre équivalent moyen compris entre 15 nm et 300 nm et dont la taille moyenne du domaine cristallin est comprise entre 15 nm et 80 nm.

Dans de telles particules poly-cristallines, le diamètre moyen du(des) domaine(s) cristallin(s) des particules constitutives du matériau solide de formule (A), mesuré par diffraction des rayons X, est inférieur au diamètre équivalent moyen desdites particules.

Avantageusement, dans cette deuxième variante d'un matériau selon l'invention, le matériau solide de formule (A) présente, par spectroscopie Raman, une raie de diffusion, dite raie primaire, présentant une intensité maximum de diffusion à une valeur de nombre d'onde comprise entre 330cm⁻¹ et 340 cm⁻¹ -notamment sensiblement de l'ordre de 336 cm⁻¹- et une largeur de raie à mi-hauteur comprise entre 5 cm⁻¹ et 40 cm⁻¹.

Avantageusement et selon une troisième variante de l'invention, la taille moyenne du(des) domaine(s) cristallin(s) des particules constitutives du matériau solide de formule (A), mesurée par diffraction des rayons X, est sensiblement de l'ordre de grandeur du diamètre équivalent moyen desdites particules.

Avantageusement dans cette troisième variante d'un matériau solide de formule (A) selon l'invention, les particules constitutives du matériau solide de formule (A) sont des particules monocristallines. De telles particules monocristallines présentent un diamètre équivalent moyen déterminé par microscopie électronique qui est de l'ordre de grandeur -notamment sensiblement égal- au diamètre moyen des domaines cristallins déterminé par diffraction des rayons X. Avantageusement, le matériau solide de formule (A) est formé de particules monocristallines.

Dans cette troisième variante, avantageusement et selon l'invention, le matériau solide de formule (A) est formé de particules présentant un diamètre équivalent moyen compris entre 25 nm et 100 nm -notamment compris entre 30 nm et 60 nm- et dont la taille moyenne du domaine cristallin est comprise entre 25 nm et 100 nm.

Avantageusement, dans cette troisième variante d'un matériau selon l'invention, le matériau solide de formule (A) présente, par spectroscopie Raman, une raie de diffusion, dite raie primaire, présentant une intensité maximum de diffusion à une valeur de nombre d'onde comprise entre 330 cm⁻¹ et 340 cm⁻¹ -notamment sensiblement de l'ordre de 336 cm⁻¹- et une largeur de raie à mi-hauteur comprise entre 5 cm⁻¹ et 18 cm⁻¹.

Avantageusement et selon l'invention, le matériau solide de formule (A) présente, par spectroscopie Raman, une raie de diffusion secondaire, présentant une intensité maximum de diffusion à une valeur de nombre d'onde comprise entre 260 cm⁻¹ et 295 cm⁻¹, notamment entre 260 cm⁻¹ et 285 cm⁻¹.

Avantageusement, le matériau solide de formule (A) présente, par spectroscopie Raman, une raie de diffusion secondaire additionnelle, présentant une intensité maximum de diffusion à une valeur de nombre d'onde comprise entre 355 cm⁻¹ et 375 cm⁻¹ -notamment comprise entre 360 cm⁻¹ et 370 cm⁻¹, préférentiellement de l'ordre de 365 cm⁻¹.

Avantageusement, il est possible que la teneur *d* en soufre d'un matériau solide de formule (A) soit supérieure à 4 compte tenu de la présence de la présence résiduelle de produits de décomposition du précurseur de soufre.

Dans un mode de réalisation particulier de l'invention, le matériau solide est de formule (A) dans laquelle:
○ 1,6 < *a* < 2,4 ;
○ *u*=0;
○ 0,6 < *b* < 1,2 ;
○ *v*=0 ;
○ 0,6 < *c* < 1,2 ;
○ *w*=0 ;
○ y=0 ;
○ 3,5 < *d* < 4,5 ;
○ *x*=0.

Dans un mode de réalisation, avantageusement et selon l'invention, le matériau solide est de formule (A₁) suivante :

(Cu⁺¹₂ ; Zn⁺²₁ ; Sn⁺⁴₁ ; S⁻²₄) (A₁),

découlant de la formule (A) dans laquelle *a = 2 ; u =* 0 *; b =* 1 *; v =* 0 *; c =* 1 *; w =* 0 *; y* = 0 ; *d* = 4 et *x* = 0.

Dans un autre mode de réalisation particulier de l'invention, le matériau solide est de formule (A) dans laquelle :
- 1,6 < *a* < 2,4;
- *u*=0 ;
- 0,6 < *b* < 1,2 ;
- 0 ≤ *v* < 0,5 ;
- 0,6 < *c* < 1,2 ;
- *w*=0;
- *y* = 0 ;
- 3,5 < *d* < 4,5;
- *x* = 0.

Dans ce mode de réalisation, avantageusement et selon l'invention, le matériau solide est de formule (A₂) suivante:

(Cu⁺¹₂ ; Zn⁺²*_{b-v}* ; Cd⁺²*ᵥ* ; Sn⁺⁴₁ ; S⁻²₄) (A₂),

découlant de la formule (A) dans laquelle *a* = 2 ; *u* = 0 ; 0,6 *< b* < 1,2 ; 0 ≤ *ν* < 0,5 ; *c =* 1 *; w =* 0 ; *y =* 0 *; d =* 4 et *x =* 0.

Plus particulièrement et avantageusement selon l'invention, le matériau solide est un matériau dopé de formule (A) dans laquelle :
- *a* = 2 ;
- *u* = 0 ;
- *b* = 1 ;
- 0 ≤ *v* < 0,5 ;
- *c* = 1 ;
- *w* = 0 ;
- *y* = 0,
- *d* = 4 ;
- *x* = 0.

Avantageusement et selon l'invention, le matériau solide est un matériau dopé de formule (A₃) :

(Cu⁺¹₂ ; Zn⁺²_{0.75} ; Cd⁺²_{0.25} ; Sn⁺⁴₁ ; S⁻²₄) (A₃),

découlant de la formule (A) dans laquelle *a =* 2 *; u =* 0 *; b =* 1 *; ν =* 0,25 ; *c* = 1 ; *w* = 0 ; *y* = 0 *; d =* 4 et *x =* 0.

Dans un autre mode de réalisation particulier de l'invention, le matériau solide est un matériau dopé de formule (A) dans laquelle:
- 1,6 < *a* < 2,4;
- *u* = 0 ;
- 0,6 < *b* < 1,2 ;
- 0≤ *ν* <0,5 ;
- 0,6 < *c* < 1,2 ;
- *w* = 0 ;
- 0 ≤ y < 0,5 ;
- 3,5 < *d* < 4,5;
- *x* = 0 ;
- *²X⁺³* est choisi dans le groupe formé des cations du gallium (Ga), des cations de l'indium (In) et des cations de l'yttrium (Y).

Dans ce mode particulier de réalisation de l'invention, avantageusement le matériau solide dopé est de formule (A₄) :

(Cu⁺¹₂; Zn⁺²_{0,75} ; Ga⁺³0,5 ; Sn⁺⁴0,75 ; S⁻²₄) (A₄),

découlant de la formule (A) dans laquelle *²X⁺³* est Ga⁺³ ; *a* = 2 ; *u* = 0; *b* = 1 ; *v* = 0 ; *c* = 1 ; *w* = 0 ; *y* = 0,5 ; *d* = 4 et *x* = 0.

Dans un autre mode de réalisation particulier de l'invention, le matériau solide est un matériau dopé de formule (A) dans laquelle:
- 1,6 < *a* < 2,4;
- *u* = 0 ;
- 0,6 < *b* < 1,2 ;
- *ν* = 0 ;
- 0,6 < *c* < 1,2;
- 0 ≤ *w <* 0,5 ;
- *w* = 0 ;
- 3,5 < *d* < 4,5;
- *x* = 0 ;
- ¹*X*⁺⁴ est choisi dans le groupe formé des cations du titane (Ti), des cations du zirconium (Zr) et des cations du plomb (Pb).

Dans ce mode particulier de réalisation de l'invention, avantageusement le matériau solide est un matériau dopé de formule (A₅) :

(Cu⁺¹₂ ; Zn⁺²₁ ; Sn⁺⁴_{c-w} ; Zr⁺⁴_{w} ; S⁻²₄) (A₅),

découlant de la formule (A) dans laquelle *¹X⁺⁴* est Zr⁺⁴; *a* = 2 ; *u* = 0 ; *b* = 1 ; *v* = 0 ; *c* = 1 ; 0 ≤ *w* <0,5 ; y = 0 ; *d* = 4 et *x* = 0.

Dans un autre mode de réalisation particulier de l'invention, le matériau solide est un matériau dopé de formule (A₆) :

( Cu⁺¹*ₐ₋ᵤ ;* Ag⁺¹*ᵤ* ; Zn⁺²*_{b} ;* Sn⁺⁴*_{c}* ;S⁻²*_{d}*) (A₆),

découlant de la formule (A) dans laquelle 1,6 < *a* < 2,4 ; 0 ≤ *u* < 0,5 ; 0,6 *< b* < 1,2 ; *v* = 0 ; 0,6 < *c* < 1,2 ; *w* = 0 ; *y* = 0 ; 3,5 < *d* < 4,5 et *x* = 0.

Dans un autre mode de réalisation particulier de l'invention, le matériau solide est un matériau dopé de formule (A₇) :

(Cu⁺¹*ₐ* ; Zn⁺²*_{b}* ; Sn⁺⁴*c* ; S⁻²*_{d-x}* ; Se⁻²ₓ) (A₇),

découlant de la formule (A) dans laquelle 1,6 < *a* < 2,4 ; *u* = 0 ; 0,6 < b < 1,2 ; *v* = 0 ; 0,6 < *c* < 1,2 ; *w = 0 ; y* = 0; 3,5 < *d* < 4,5 et 0 ≤ *x* < 0,5.

Avantageusement et selon l'invention, un matériau solide de formule (A) peut présenter au moins l'une des caractéristiques suivantes :
- une fraction des cations du cuivre (Cu⁺¹) est substituée par des cations de l'argent (Ag⁺¹),
- une fraction des cations du zinc (Zn⁺²) est substituée par des cations du cadmium (Cd⁺²),
- une fraction des cations de l'étain (Sn⁺⁴) est substituée par des cations du titane (Ti⁺⁴), du zirconium (Zr⁺⁴) ou du plomb (Pb⁺⁴),
- une même fraction des cations du zinc (Zn⁺²) et des cations de l'étain (Sn⁺⁴⁾ est substituée par des cations choisis dans le groupe formé des cations du gallium (Ga⁺³), des cations de l'indium (In⁺³) et de l'yttrium (Y⁺³),
- une fraction des anions du soufre (S⁻²) est substituée par des anions du sélénium (Se⁻²).

L'invention s'étend aussi à un procédé d'obtention d'un matériau solide de formule (A).

L'invention concerne aussi un procédé d'obtention d'un matériau solide de formule (A) selon l'invention, ledit procédé comprenant les étapes suivantes :
- (a) on choisit au moins un précurseur de chaque élément constitutif du matériau solide de formule (A) ;
- (b) on prépare une composition, dite composition de précurseurs, solide par mélange du(des) précurseurs de chaque élément constitutif du matériau solide de formule (A), puis ;
- (c) on place cette composition de précurseurs dans une enceinte sous atmosphère d'un gaz inerte à une température de l'ordre de la température ambiante ;
- (d) on chauffe la composition de précurseurs lors d'une étape, dite étape en sels fondus, selon un taux d'accroissement de la température compris entre 0,5°C/min et 10,0°C/min et adapté pour que la température de l'enceinte atteigne une température de synthèse, comprise entre 250°C et 500°C-notamment comprise entre 350°C et 450°C-, et on maintient ladite température de synthèse pendant une durée de synthèse, comprise entre 2 h et 36 h -notamment comprise entre 4 h et 26 h- de façon à former un matériau recristallisé présentant une structure unique par diffraction des rayons X, puis,
- (e) on réalise, après refroidissement du matériau recristallisé, un traitement de séparation d'un matériau solide de formule (A) exempt de précurseurs,
- (f) ultérieurement à ces étapes (a) à (e), on soumet le matériau solide de formule (A) exempt de précurseurs à une étape de réduction de sa granulométrie -notamment par broyage-,
- (g) puis on réalise une étape de sélection des particules du matériau de granulométrie ainsi réduite adaptée pour conserver les particules de granulométrie la plus faible.

Les inventeurs ont observé qu'un tel traitement en sels fondus d'une composition de précurseurs, à une température comprise entre 250°C et 500°C -notamment comprise entre 350°C et 450°C- permet de former des particules cristallines d'un matériau solide de formule (A) et de taille nanométrique par précipitation ou, de préférence, par dissolution/re-précipitation accompagné d'une recristallisation, de ladite composition de précurseurs. De façon totalement surprenante, les inventeurs ont observé qu'un tel traitement en sels fondus d'une composition de précurseurs, notamment d'une poudre de précurseurs peu cristallisés permet, sans modifier sensiblement la granulométrie de la poudre, d'augmenter la taille et la qualité cristallographique des domaines cristallisés des particules constitutives de la composition de précurseurs.

Bien qu'aucune explication à ce phénomène ne soit connue, les inventeurs pensent que l'eau constitutivement liée aux précurseurs cationiques et anioniques provoque, lors du chauffage desdits précurseurs, un bullage du milieu réactionnel en fusion dû à l'eau de constitution et un réarrangement avec expansion du volume réactionnel.

Avantageusement et selon l'invention, dans un tel procédé :
- les proportions molaires (*a', u', b', v', c',* y' et w') respectives des éléments Cu, Ag, Zn, Cd, Sn, *¹X* et *²X* constitutifs de la composition de précurseurs sont dans les proportions stoechiométriques *a, u, b, v, c*, *y* et *w* respectives du matériau solide de formule (A) ;
- les proportions molaires (d' et x') respectives des éléments S et Se constitutifs de la composition de précurseurs sont telles que la somme (d' + x') est comprise entre 5 et 30 -notamment comprise entre 8 et 25-,
- lesdites valeurs (*a', u', b', v', c', y*', *w*', *d*' et *x*') étant adaptées pour satisfaire la condition d'électro-neutralité du matériau solide de formule (A).

Avantageusement et selon l'invention, on choisit :
- le(s) précurseur(s) de cuivre (Cu) dans le groupe formé du chlorure cuivreux (CuCl), du chlorure cuivrique di-hydraté (CuCl₂ 2H₂O), du nitrate de cuivre (Cu(NO₃)₂), de l'acétate de cuivre (CH₃COO)₂Cu), des hydroxydes de Cu fraichement préparés et des (oxy)hydroxydes de Cu fraichement préparés ;
- le(s) précurseur(s) d'étain (Sn) dans le groupe formé du chlorure stannique hydraté (SnCl₄ 5H₂O), de l'acétate stannique (CH₃COO)₄Sn), des hydroxydes de Sn⁺⁴ fraichement préparés et des (oxy)hydroxydes de Sn⁺⁴ fraichement préparés ;
- le(s) précurseur(s) de zinc (Zn) dans le groupe formé du chlorure de zinc (ZnCl₂), de l'acétate de zinc (CH₃COO)₂Zn), des hydroxydes de Zn⁺² fraichement préparés et des (oxy)hydroxydes de Zn⁺² fraichement préparés ;
- le(s) précurseurs(s) d'anion(s) dans le groupe formé du thiocyanate de potassium (K-S-C=N), de la thio-urée (S=C(NH₂)₂) du sulfure de sodium hydraté (Na₂S, 9H₂O), du sulfure de sodium (Na₂S), du sélénocyanate de potassium (K-Se-C=N) et de la séléno-urée (Se=C(NH₂)₂),
- le(s) précurseurs(s) de dopant(s) dans le groupe formé du nitrate d'argent (AgNO₃), du chlorure de gallium (GaCl₃), du chlorure de cadmium (CdCl₂), du nitrate de gallium (Ga(NO₃)₃), du nitrate de cadmium (Cd(NO₃)₃), de l'iodure de cadmium (CdI₂) et de l'acétate de plomb (CH₃COO)₄Pb), du nitrate d'yttrium (Y(NO₃)₃), des (oxy)hydroxydes de gallium, des (oxy)hydroxydes de plomb et des (oxy)hydroxydes d'yttrium.

Dans une première variante d'un procédé, avantageusement et selon l'invention, on soumet directement la composition de précurseurs à l'étape en sels fondus.

Dans cette première variante d'un procédé selon l'invention, on réalise un mélange des précurseurs du matériau solide, puis on soumet le mélange à un traitement en sels fondus selon l'invention. On obtient une composition de particules présentant un diamètre équivalent moyen compris entre 15 nm et 400 nm, notamment compris entre 25 nm et 300 nm, en particulier entre 25 nm et 100 nm, et formées d'un matériau solide de formule (A), ledit matériau solide étant hautement cristallin.

Dans une deuxième variante d'un procédé, avantageusement et selon l'invention, après l'étape (a) ;
- on prépare une solution, dite solution de précurseurs, par mélange du(des) précurseur(s) de chaque élément constitutif du matériau solide de formule (A) dans un milieu liquide, dit milieu solvant, comprenant au moins un composé liquide choisi dans le groupe formé de l'éthylène glycol, de l'acétonitrile et des alcools -notamment de l'alcool éthylique et de l'isopropanol-, puis ;
- on réalise un traitement, dit traitement solvothermal, de ladite solution de précurseurs dans un réacteur clos à une température comprise entre 140°C et 250°C -notamment entre 180°C et 220°C- pendant une durée comprise entre 8 h et 24 h -notamment une durée comprise entre 12 h et 18 h-, puis,
- on réalise une étape de séparation solide/liquide d'un solide formé lors du traitement solvothermal dans ladite solution de précurseurs, puis,
- on réalise un broyage dudit solide de façon à former une poudre finement divisée, puis,
- on soumet la poudre finement divisée à l'étape en sels fondus.

Lors du traitement solvothermal, la pression à l'intérieur du réacteur clos est la pression autogène due à l'augmentation de température de la solution de précurseur dans le milieu solvant.

Dans la solution de précurseurs, les proportions molaires (*a"*; *u", b", v" c", y"* et *w"*) respectives des éléments Cu, Ag, Zn, Cd, Sn, *¹X* et *²X* constitutifs de la solution de précurseurs sont dans les proportions stoechiométriques *a, u, b, v*, *c*, *y* et *w* respectives du matériau solide de formule (A) ;
- les proportions molaires *(d' et* x') respectives des éléments S et Se constitutifs de la solution de précurseurs sont telles que la somme (d' + *x')* est comprise entre 4 et 15 -notamment comprise entre 5 et 12-,
- lesdites valeurs (*a"; u", b", v", c", y", w", d"* et *x*") étant adaptées pour permettre de satisfaire la condition d'électro-neutralité du matériau solide de formule (A) obtenu par le procédé selon l'invention.

Dans cette deuxième variante, on soumet ensuite la poudre finement divisée aux étapes successives ultérieures (c), (d), (e), (f) et (g) d'un traitement en sels fondus d'un procédé selon l'invention.

Dans cette deuxième variante d'un procédé selon l'invention, on forme d'abord une poudre finement divisée formée d'un matériau selon l'invention présentant, par diffraction des rayons X, une phase cristalline de taille moyenne comprise entre 4 nm et 12 nm et une proportion de matière amorphe. Les particules de la poudre finement divisée présentent un diamètre équivalent moyen compris entre 15 nm et 400 nm, notamment entre 25 nm et 300 nm, en particulier entre 25 nm et 250 nm.

Les inventeurs ont observé que le traitement en sels fondus d'une telle poudre finement divisée, à une température comprise entre 250°C et 500°C -notamment comprise entre 350°C et 450°C- permet de former des particules selon l'invention de taille nanométrique présentant un domaine cristallin unique de grande taille.

Dans cette deuxième variante d'un procédé selon l'invention, avantageusement on obtient un matériau solide de formule (A) présentant une proportion de particules monocristallines supérieure à 80%, lesdites particules présentant un diamètre équivalent moyen compris entre 25 nm et 100 nm et une taille de domaine cristallins unique comprise entre 25 nm et 100 nm.

Les inventeurs ont observé qu'une concentration élevée de précurseur(s) d'anions choisis dans le groupe formé du soufre (S) et du sélénium (Se) lors du traitement solvothermal de ladite solution de précurseurs est adaptée pour permettre la formation d'un solide finement divisé, dans lequel les particules sont de faible diamètre équivalent moyen et présentent, par analyse par diffraction des RX, des domaines cristallins organisés de petite taille.

Avantageusement, la solution de précurseurs comprend en outre au moins un agent réducteur -notamment l'acide ascorbique- dans une proportion molaire agent réducteur/cuivre (Cu) comprise entre 0,5 et 1,5, préférentiellement entre 0,8 et 1,2 et adaptée pour permettre la réduction des ions Cu⁺⁺ en ions Cu⁺ dans ladite solution de précurseurs.

Avantageusement, la concentration molaire en ions Cu⁺⁺ dans la solution de précurseurs est comprise entre 0,02 M et 0,2 M, préférentiellement entre 0,02 M et 0,05 M.

Avantageusement, la solution de précurseurs comprend une quantité d'au moins un composé basique, susceptible de produire des ions hydroxydes dans ladite solution de précurseurs. Avantageusement, on choisit le composé basique dans le groupe formé de l'hydroxyde de sodium, de l'ammoniaque et de l'hydroxyde de tétra-méthyle-ammonium (TMaOH).

Avantageusement et selon l'invention, lors de l'étape en sels fondus, le taux d'accroissement de la température de ladite enceinte est compris entre 1°C/min et 2°C/min et la température de synthèse est comprise entre 350°C et 460°C.

Avantageusement et selon l'invention, le gaz inerte est choisi dans le groupe formé de l'argon (Ar) et de l'azote moléculaire (N₂).

L'invention vise aussi un matériau solide de formule (A) obtenu par un procédé selon l'une des variantes de l'invention.

L'invention vise en outre l'utilisation d'un matériau solide de formule (A) selon l'invention dans laquelle on réalise une dispersion dudit matériau solide de formule (A) dans un milieu liquide, dit liquide de dispersion, formé d'au moins un composé présentant une valeur de δₚ supérieure à 8 -en particulier une valeur de δₚ comprise entre 8 et 20- et une valeur de δ_{H} supérieure à 5 -en particulier une valeur de δ_{H} comprise entre 5 et 40-.

L'invention vise aussi l'utilisation d'un tel matériau solide de formule (A) obtenu par un procédé selon l'invention, dans laquelle on réalise une dispersion dudit matériau solide de formule (A) dans un milieu liquide, dit liquide de dispersion, formé d'au moins un composé présentant une valeur de δₚ supérieure à 8 -en particulier une valeur de δₚ comprise entre 8 et 20- et une valeur de δ_{H} supérieure à 5 -en particulier une valeur de δ_{H} comprise entre 5 et 40-.

Avantageusement et selon l'invention, on applique ladite dispersion sur une surface solide -notamment sur une surface extérieure d'un matériau d'électrode de cellule solaire- de façon à former un film de ladite dispersion de particules d'épaisseur comprise entre 0,1 µm et 5 µm -notamment de l'ordre de 2 pm-.

Avantageusement, on utilise un liquide de dispersion formé d'au moins un composé dont la somme (δₚ + δ_{H}) est supérieure à 22. En particulier, le liquide de dispersion est formé d'un composé unique dont la somme (δₚ + δ_{H}) est supérieure à 22.

Avantageusement, on utilise un liquide de dispersion choisi dans le groupe formé de l'alcool éthylique, de l'acétonitrile, de l'éthylène glycol, du propylène glycol, du diméthylsulfoxyde, du diméthylformamide, et des solvants soufrés.

Dans un tel procédé de réalisation d'un film pour cellule solaire, on peut éventuellement réaliser une étape de densification par frittage dudit film sous atmosphère d'un gaz inerte, d'une composition d'un gaz inerte comprenant une pression partielle de sélénium, ou sous pression réduite d'un gaz inerte à une température comprise entre 400°C et 600°C.

L'invention s'étend aussi à une dispersion d'au moins un matériau solide de formule (A) selon l'invention dans un tel liquide de dispersion. Avantageusement et selon l'invention le liquide de dispersion est choisi dans le groupe formé des solvants volatiles.

Avantageusement, la dispersion des particules dudit matériau solide de formule (A) dans le liquide de dispersion présente une concentration dudit matériau solide de formule (A) dans le liquide de dispersion supérieure à 10 g/L. Une telle dispersion dudit matériau solide de formule (A) dans le liquide de dispersion est une dispersion stable adaptée pour que plus de 70%, notamment plus de 80%, préférentiellement plus de 90% en poids du matériau solide de formule (A) restent en suspension dans le liquide de dispersion après une période d'une durée de 2 h -notamment d'une durée de 6 h, particulièrement d'une durée de 48 h, préférentiellement d'une durée de 96 h- sans agitation de ladite dispersion.

Avantageusement, une telle dispersion d'un matériau solide de formule (A) dans le liquide de dispersion est réalisée sans adjonction d'additif -notamment de composé organique, en particulier de composé tensioactif ou polyélectrolyte- susceptible de modifier la tension de surface du matériau solide de formule (A) et de ralentir la décantation d'un tel matériau en suspension ou de liant organique susceptible d'améliorer la tenue mécanique du film avant frittage.

Avantageusement, on choisit le liquide de dispersion dans le groupe formé des solvants développant de fortes interactions polaires (δₚ) et de fortes interactions hydrogènes (δ_{H}). Ces paramètres sont listés dans *«* Handbook of solubility parameters and other cohesive parameters, 1983, CRC press, p153-157*».* Ainsi on choisit plus particulièrement au moins un solvant dans le groupe formé de l'alcool éthylique (δₚ = 8,8, δ_{H} = 19,4), de l'acétonitrile (δₚ = 18, δ_{H} = 6,1), de l'éthylène glycol (δₚ = 11, δ_{H} = 26) et du diméthylsulfoxyde (δₚ = 16,4, δ_{H} = 10,2), du propylène glycol (δₚ, = 9, δ_{H} = 22), du méthanol (δₚ = 13, δ_{H} = 21) et du diméthylformamide (δₚ = 14, δ_{H} = 11).

Avantageusement, on choisit le liquide de dispersion dans le groupe formé des solvants présentant une température d'ébullition à la pression atmosphérique inférieure à 100°C, notamment de l'alcool éthylique (CH₃CH₂-OH) et de l'acétonitrile (CH₃-C≡N).

Avantageusement et selon l'invention, on utilise une telle dispersion dudit matériau solide de formule (A) dans le liquide de dispersion pour la fabrication d'un film photo-absorbant d'une cellule photovoltaïque, notamment un film photo-absorbant de faible épaisseur, en particulier d'un film photo-absorbant d'épaisseur sensiblement de l'ordre de 2 µm.

L'invention vise en outre un film photo-absorbant d'une cellule photovoltaïque, ledit film étant formé d'un matériau solide de formule (A) selon l'invention.

Un tel matériau solide de formule (A), dans lequel les particules sont de taille nanométrique et de structure hautement cristalline, est adapté pour permettre la formation d'un film photo-absorbant et de conversion de l'énergie solaire en énergie électrique de rendement accru par rapport aux matériaux photoélectriques de l'état de la technique.

Avantageusement et selon l'invention, on utilise une telle composition de particules pour la fabrication d'un film photo-catalytique.

L'invention concerne également un matériau solide de formule (A), un procédé de fabrication d'un tel matériau, une dispersion d'un tel matériau dans un solvant et l'utilisation d'une telle dispersion pour la fabrication de cellules photovoltaïques caractérisés en combinaison par tout ou partie des caractéristiques mentionnées ci-dessus ou ci-après.

D'autres buts, caractéristiques et avantages de l'invention apparaîtront à la lecture de la description suivante qui se réfère aux figures annexées illustrant des modes de réalisation préférentiels de l'invention, ainsi que des exemples non limitatifs de procédés selon l'invention, et dans lesquels :
- la figure 1 est un schéma synoptique illustrant une première variante d'un procédé selon l'invention,
- la figure 2 est un schéma synoptique illustrant une deuxième variante d'un procédé selon l'invention,

- la figure 3 est un diffractogramme des rayons X d'un matériau solide de formule (A) dopé obtenu selon l'exemple 2,
- la figure 4 est un diffractogramme des rayons X d'un matériau solide de formule (A) obtenu selon l'exemple 4,
- la figure 5 est un diffractogramme des rayons X d'un matériau solide de formule (A) obtenu selon l'exemple 7,
- la figure 6 est un spectre Raman d'un matériau solide de formule (A) obtenu selon l'exemple 8.

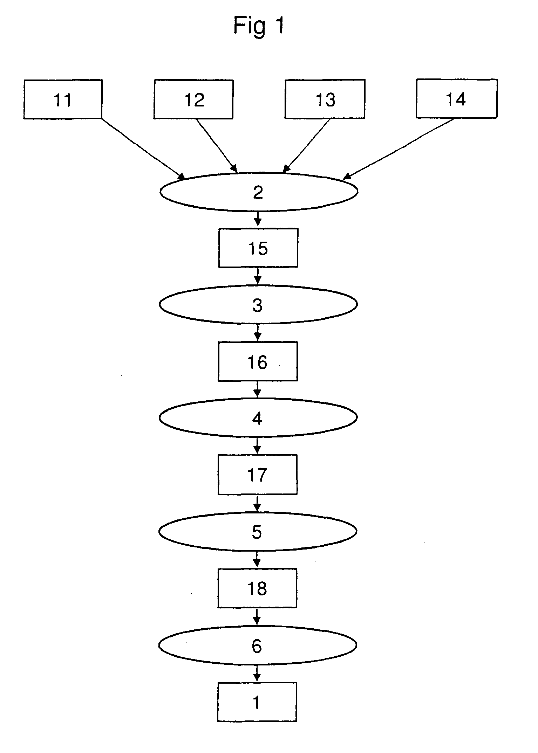

Dans un procédé selon l'invention représenté en figure 1, on prépare une composition 15 de précurseurs, lors d'une étape 2 de mélange d'un précurseur 11 de cuivre, d'un précurseur 12 d'étain, d'un précurseur 14 du zinc et d'un précurseur 13 de soufre. On réalise cette étape 2 de mélange par des moyens adaptés et connus de l'homme du métier pour permettre le mélange sensiblement homogène des précurseurs solides sous forme de poudres.

En variante non représentée on ajoute lors de l'étape 2 de mélange au moins un composé précurseur d'un élément dopant choisi dans le groupe formé des précurseurs de cations d'argent, de gallium, d'indium, de cadmium, de titane, de zirconium, de plomb et de sélénium.

On place la composition 15 de précurseurs solides dans une enceinte sous atmosphère d'une composition de gaz inerte et à la température ambiante. On chauffe ladite enceinte, lors d'une étape 3 en sels fondus, de façon que la température de la composition 15 de précurseurs solides dans l'enceinte augmente selon un taux d'accroissement de la température compris entre 0,5°C/min et 10°C/min et jusqu'à une valeur de température de synthèse qui est maintenue pendant une durée comprise entre 2 h et 36 h. Après refroidissement naturel de la température de l'enceinte jusqu'à la température ambiante, on obtient dans l'enceinte un matériau 16 recristallisé de formule (A) présentant une raie unique en diffraction des rayons X. On soumet le matériau 16 recristallisé à une étape 4 d'élimination des précurseurs résiduels lors de laquelle le matériau 16 recristallisé est repris dans l'eau de façon à solubiliser les précurseurs 11, 12, 13, 14 résiduels en excès et éventuellement les sous-produits formés tout en préservant de la solubilisation le matériau 16 recristallisé. On récupère alors par un traitement de séparation solide/liquide le matériau 17 recristallisé qui est sensiblement exempt de précurseurs 11, 12, 13, 14 résiduels.

On soumet le matériau 17 recristallisé à une étape de broyage 5 par attrition dudit matériau 17 recristallisé adapté pour former un matériau 18 solide de faible granulométrie. Après l'étape 5 de broyage du matériau 17 cristallisé, on réalise un traitement 6 de sélection des particules de plus basse granulométrie, lors duquel on réalise au moins une étape de centrifugation différentielle adaptée pour permettre une sédimentation différentielle des particules du matériau (1) solide en fonction de leur taille.

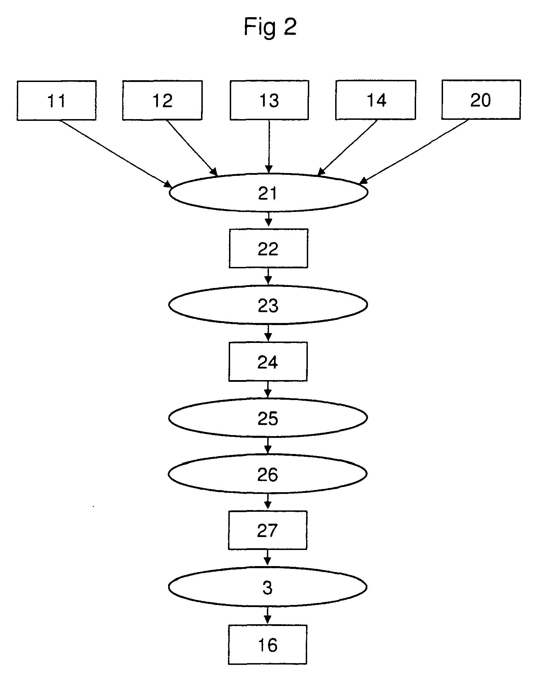

Dans un procédé selon l'invention représenté en figure 2, on prépare par dissolution 21 une solution 22 d'un précurseur 11 de cuivre, d'un précurseur 12 d'étain, d'un précurseur 14 du zinc et d'un précurseur 13 de soufre dans un milieu 20 solvant. On réalise cette étape 21 de dissolution des précurseurs 11, 12, 13, 14 dans le milieu solvant par des moyens connus en soi, en particulier par agitation magnétique à une température proche de la température ambiante.

En variante non représentée, on ajoute lors de l'étape 21 de dissolution des précurseurs au moins un composé précurseur d'un élément dopant choisi dans le groupe formé des précurseurs de cations d'argent, de gallium, d'indium, de cadmium, de titane, de zirconium, de plomb et de sélénium.

Dans une autre variante non représentée, on ajoute lors de cette étape 21 de dissolution une quantité d'au moins un composé réducteur adapté pour permettre la réduction des ions Cu⁺⁺ et Cu⁺ dans la solution 22 de précurseurs.

On place la solution 22 de précurseurs dans l'enceinte close et étanche -notamment aux liquides et aux gaz- d'un autoclave non agité et préalablement chauffé à une température comprise entre 140°C et 250°C et on maintien, lors de l'étape 23 thermique, la solution 22 de précurseurs dans cette enceinte pendant une durée comprise entre 8 h et 24 h. Après retour de la solution 22 de précurseur à la température ambiante, on sépare le résidu 24 solide formé et le surnageant liquide par séparation 25 solide/liquide, notamment par centrifugation. On élimine le surnageant séparé par centrifugation et on procède à un rinçage dudit résidu 24 solide avec de l'alcool éthylique à la température ambiante.

On soumet le résidu 24 solide rincé à l'alcool éthylique à un traitement 26 de broyage adapté pour permettre de réduire la granulométrie du résidu 24 solide. On réalise ce traitement 26 de broyage avec un dispositif connu en soi de l'homme du métier tel qu'un broyeur de type *« attritor* ». On soumet le résidu 24 solide à un tel traitement 26 de broyage dans lequel on place le résidu 24 solide en suspension dans de l'alcool éthylique en présence de billes d'un matériau solide de granulométrie de l'ordre de 0,3 mm pendant une durée adaptée pour permettre une diminution de la granulométrie du résidu 24 solide dans la suspension éthylique.

On élimine les billes de matériau solide (notamment par filtration) et on obtient une poudre 27 finement divisée que l'on soumet à une étape 3 en sels fondus de recristallisation des particules de la poudre 27 finement divisée. On obtient un matériau 16 recristallisé de formule (A) présentant une raie unique en diffraction des rayons X et une taille moyenne de domaine cristallisé élevée. Le matériau 16 recristallisé est traité ultérieurement comme décrit figure 1.

En variante non représentée, on soumet cette poudre 27 finement divisée à une étape de sélection des particules de plus basse granulométrie par exemple par centrifugation adaptée pour permettre une élimination par sédimentation des particules de taille supérieure à 400 nm et le maintien en suspension des particules de taille inférieure à 400 nm.

EXEMPLE 1 - Procédé de fabrication d'un matériau solide à base de Cu, Zn, Sn et S à partir d'une poudre de sels métalliques sous forme de chlorures.

On prépare une composition de poudres comprenant 0,674 g de chlorure de cuivre(I) (CuCl, PROLABO, France, 6,8 mmoles), 0,465 g de chlorure de zinc(II) (ZnCl₂, ALDRICH, France, 3,41 mmoles), 1,196 g de chlorure d'étain(IV) (SnCl₄ 5H₂O, ACROS, France, 3,41 mmoles) et 3,308 g de thiocyanate de potassium (K-S-C≡N, FLUKA ALDRICH, France, 34 mmoles). On place cette composition de poudres dans un mélangeur de façon à former un mélange homogène présentant des proportions molaires en (Cu, Zn, Sn, S) de (2, 1, 1, 10).

### Traitement thermique en sels fondus

On transfère cette composition de poudre dans un creuset en alumine que l'on place dans l'enceinte d'un réacteur adapté pour permettre le renouvellement de son atmosphère. On insère ledit réacteur dans un four tubulaire vertical. On réalise une purge de l'atmosphère du réacteur avec de l'azote gazeux (N₂). On chauffe le creuset, au moyen du four, de façon à augmenter la température de l'enceinte à partir de la température ambiante jusqu'à la valeur de 400°C en 6 h. On maintient, toujours sous un courant d'azote gazeux, la température de 400°C dans l'enceinte du réacteur pendant 24 heures, puis on laisse le creuset refroidir naturellement jusqu'à la température ambiante. On obtient un matériau solide aéré, de volume apparent augmenté par rapport à la composition de poudre initiale.

### Extraction du matériau solide

On reprend le matériau solide aéré avec un volume de 200 mL d'eau. On incube la suspension aqueuse obtenue sous agitation pendant 1 h de façon à dissoudre les sels résiduels et le thiocyanate en excès dans l'eau. On obtient un matériau solide de couleur noire que l'on sépare de la phase aqueuse par sédimentation, notamment par centrifugation à 1720 g pendant une durée de 20 min. On lave à nouveau le matériau solide de couleur noire avec 200 mL d'une solution d'alcool éthylique et on sèche le matériau solide obtenu à l'air et à température ambiante.

### Broyage du matériau solide

On place 10 g du matériau solide sec tel qu'obtenu ci-dessus, 27 g de billes de broyage formées d'alumine cristalline (Al₂O₃) de granulométrie de l'ordre de 0,4 mm et 20 mL d'alcool éthylique dans le réceptacle (de dimensions utiles 40 mm x 85 mm) d'un broyeur à attrition. On soumet cette préparation à un traitement par broyage pendant une durée d'une heure à la température ambiante. On sépare par filtration les billes de broyage et le matériau solide en suspension dans l'alcool éthylique. On soumet ladite suspension du matériau solide à une étape de centrifugation à 1720 g pendant 20 min à la température ambiante. On obtient un culot (Cl), contenant le matériau solide, et un surnageant liquide qui est éliminé. On lave les billes de broyage précédemment récupérées avec 600 mL d'alcool éthylique pour former une suspension de lavage et on ajoute cette suspension de lavage au culot (Cl) pour former une suspension secondaire du matériau solide dans l'alcool éthylique. On renouvelle l'étape de lavage des billes de broyage et on ajoute les suspensions de lavage des billes au culot (Cl).

On traite cette suspension du matériau solide dans l'éthanol par les ultrasons et on réalise une centrifugation à une vitesse de 1720 g pendant 20 min à la température ambiante lors de laquelle les particules formant le matériau solide sédimentent. On élimine le surnageant de centrifugation et on disperse le matériau solide sédimenté dans un volume d'acétonitrile (CH₃-C≡N, ALDRICH, France). On centrifuge, à 500 g pendant 20 min et à température ambiante, la suspension du matériau solide dans l'acétonitrile. On obtient un précipité et une suspension de couleur noire contenant le matériau solide selon l'invention dans l'acétonitrile.

### Analyses

L'analyse de ce matériau solide par microscopie électronique à transmission montre des particules individualisées dont le diamètre apparent moyen est de l'ordre de 0,2 µm.

Le spectre de diffraction des rayons X du matériau solide obtenu après séchage de la suspension dans l'acétonitrile est caractéristique d'une structure (Cu₂ZnSnS₄) unique. L'analyse de ce spectre par la méthode de Debye et Scherrer montre des domaines organisés cristallins dont la taille apparente moyenne est de l'ordre de 12 nm.

EXEMPLE 2 - Procédé de fabrication d'un matériau solide dopé à base de Cu, Zn, Sn, Ga, S à partir d'une solution de sels métalliques sous forme de chlorures.

A une solution de chlorure de gallium(III) (GaCl₃, ALDRICH, France) dans 46,1 mL d'alcool éthylique (0.119g de GaCl₃, 1,705 mmoles), on ajoute 0,348 g de chlorure de zinc(II) (ZnCl₂, ALDRICH, France, 2,55 mmoles), 0,894 g de chlorure d'étain(IV) (SnCl₄-5H₂O, ACROS, France, 2,55 mmoles) et 0,672 g de chlorure de cuivre(I) (CuCl, PROLABO, France, 6,8 mmoles). On réalise la solubilisation des espèces salines dans l'alcool éthylique par agitation magnétique et traitement par les ultrasons. On évapore l'alcool éthylique de la solution sous pression réduite à la température de 80°C. Au solide pâteux obtenu après évaporation de l'alcool éthylique, on ajoute 4,95 g de thiocyanate de potassium (K-S-C≡N, 51 mmoles). Les proportions molaires (Cu , Zn , Sn , Ga , S) dans le mélange sont (2, 0,75 , 0,75 , 0,5 , 15).

On réalise les étapes de fusion, d'extraction et de broyage selon le mode de réalisation décrit à l'exemple 1.

### Analyses

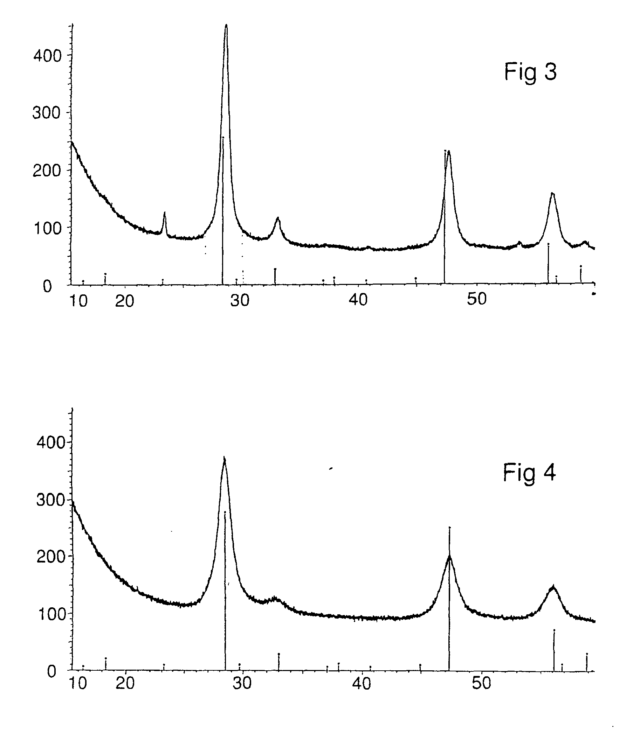

L'analyse de ce matériau solide par microscopie électronique à transmission montre des particules individualisées dont le diamètre apparent moyen est de l'ordre de 0,2 µm et présentant des cristallites primaires de taille de l'ordre de 25 nm. Le spectre de diffraction des rayons X (figure 3) de la poudre obtenue après séchage de la suspension du matériau solide est caractéristique d'une structure cristalline unique dans lequel les raies sont décalées vers les fortes valeurs de 2 tétha. L'analyse par modélisation selon la méthode de Debye et Scherrer montre des domaines organisés cristallins dont la taille apparente moyenne est de l'ordre de 16 nm. Le spectre de diffusion Raman montre une raie large centrée à 330 cm⁻¹ dont la largeur à mi-hauteur est de 50 cm⁻¹.

En outre, l'analyse par spectroscopie NIR-UV-VIS d'une dispersion réalisée dans l'acétonitrile montre une valeur de largeur de bande interdite de 2,23 eV.

EXEMPLE 3 - Fabrication d'un matériau solide dopé à base de Cu, Zn, Cd, Sn, S à partir d'une poudre de sels métalliques sous forme de chlorures.

On prépare une composition de poudres comprenant 0,683 g de chlorure de cuivre(I) (CuCl, 6,9 mmoles), 0,352 g de chlorure de zinc(II) (ZnCl₂, 2,58 mmoles), 1,212 g de chlorure d'étain(IV) (SnCl₄-5H₂O, 3,46 mmoles), 0,189g de chlorure de cadmium(II) (CdCl₂-2H₂O, 0,86 mmoles) et 6,724 g de thiocyanate de potassium (K-S-C≡N, 70 mmoles). On homogénéise cette composition de poudres par des moyens connus en eux-mêmes. On obtient un mélange (Cu , Zn , Cd , Sn , S) dans des proportions molaires de (2 , 0,75 , 0,25 , 1, 20).

### Traitement thermique en sels fondus

On réalise le traitement thermique en sel fondus conformément à l'exemple 1 mais dans lequel la température synthèse est de 450°C. On réalise les étapes d'extraction et de broyage selon le mode de réalisation décrit à l'exemple 1.

### Analyses

L'analyse de ce matériau solide par microscopie électronique à transmission montre des particules individualisées dont le diamètre apparent moyen est de l'ordre de 0,2 µm et présentant des cristallites primaires dont le diamètre équivalent moyen est de l'ordre de 30 nm.

Le spectre de diffraction des rayons X du matériau solide obtenue après séchage est caractéristique d'une structure cristalline unique dans lequel les raies sont décalées vers les faibles valeurs de 2 tétha.

EXEMPLE 4 - Préparation d'un matériau solide selon l'invention à base de Cu, Zn, Sn, S par traitement solvothermal d'une solution éthanolique de précurseurs métalliques sous forme de chlorures.

Dans 200 mL d'alcool éthylique absolu, on introduit 1,577 g de chlorure d'étain(IV) hydraté (SnCl₄ 5H₂O, 4,5 mmoles), 0,614 g de chlorure de zinc(II) (ZnCl₂, 4,5 mmoles) et 1,534 g de chlorure de cuivre(II) (CuCl₂-2H₂O, 9 mmoles). On maintient la suspension des sels métalliques ainsi formée sous agitation jusqu'à complète dissolution desdits sels métalliques dans l'alcool éthylique absolu. On ajoute ensuite à la solution de Sn(IV), Cu(II) et Zn(II), 2,054 g de thio-urée (CS(NH₂)₂, FLUKA ALDRICH, France, 27 mmoles) et on maintient l'agitation de ladite solution pendant 10 min à la température ambiante. On ajoute ensuite sous agitation et à température ambiante, 1,584 g d'acide ascorbique (C₆H₈O₆, ALDRICH, France, 9 mmoles), on complète à 240 mL le volume de la solution avec de l'alcool éthylique absolu et on laisse le mélange sous agitation pendant 20 min supplémentaires.

On place ce mélange dans un creuset en téflon et disposé dans un autoclave (bombe de Parr) à la température de 200°C pendant 16 h. L'autoclave est ensuite refroidit par déclin thermique naturel jusqu'à la température ambiante. On obtient un précipité que l'on sépare de l'alcool éthylique par centrifugation à 1720 g pendant 20 min à la température ambiante. On lave deux fois le précipité avec 240 mL d'alcool éthylique et on récupère le précipité par centrifugation. Après séchage à température ambiante pendant 48 h, on pèse le précipité (m = 1,4 g).

### Broyage du matériau solide

On place le précipité obtenu ci-dessus, 27 g de billes de broyage formées d'alumine cristalline (Al₂O₃) de granulométrie de l'ordre de 0,3 mm et 15 mL d'alcool éthylique dans le réceptacle (de dimensions utiles 40 mm x 85 mm) d'un broyeur à attrition. On soumet cette préparation à un traitement broyage pendant une durée d'une heure à la température ambiante adapté pour permettre la formation d'un matériau solide en suspension dans l'alcool éthylique. On sépare par filtration les billes de broyage et la suspension dudit matériau solide. On réalise un lavage des billes de broyage à l'alcool éthylique lors duquel on traite la suspension alternativement par les ultrasons et par agitation magnétique. On regroupe les suspensions contenant le matériau solide obtenues par lavages successifs des billes de broyage pour former une suspension du matériau solide de volume de l'ordre de 600 mL.

On centrifuge cette suspension à 2080 g pendant 20 min et on sépare le culot et le surnageant coloré (marron/noir) ainsi obtenus. On reprend le culot dans 1500 mL d'alcool éthylique, on traite la suspension alternativement par les ultrasons et par agitation magnétique et on centrifuge celle-ci à 1720 g pendant 10 min. On prélève ce surnageant que l'on mélange au surnageant coloré pour former une suspension du matériau solide selon l'invention.

### Analyses

L'analyse d'une fraction aliquote de cette suspension par microscopie électronique à transmission montre des objets individualisés de diamètre équivalent moyen sensiblement de l'ordre de 150 nm et se présentant sous la forme d'agrégats de cristaux élémentaires de diamètre équivalent moyen de l'ordre de 10 nm.

On sèche la suspension de particules par évaporation de l'alcool éthylique de façon à former une poudre dont la masse est de 1,1 g. Le spectre de diffraction des rayons X (figure 4) de cette poudre montre une structure unique (Cu₂ ; Zn ; Sn ; S₄). La taille des domaines organisés déterminée par la méthode de Debye et Scherrer montre des domaines organisés cristallins dont le diamètre apparent moyen est de l'ordre de 10 nm.

EXEMPLE 5 - Fabrication d'un matériau solide selon l'invention à base de Cu, Zn, Sn, S selon l'invention par traitement d'une poudre de particules polycristallines.

On mélange 0,5 g de la poudre de particules (Cu₂ ; Zn ; Sn ; S₄) obtenue à l'issue du procédé décrit à l'exemple 4 avec 1,66 g de thiocyanate de potassium. La proportion molaire (S)/(Cu) dans le mélange est de 7,5. Le mélange, placé dans un creuset en alumine, est introduit dans une enceinte sous atmosphère d'azote à la température ambiante. On chauffe l'enceinte de façon que sa température augmente régulièrement et atteigne 400°C en 150 min, puis on maintient cette température de 400°C dans l'enceinte pendant 16 h. Après refroidissement naturel de l'enceinte, on reprend la poudre calcinée dans 200 mL d'eau déminéralisée et on homogénéise la suspension par agitation magnétique pendant 30 min de façon que le thiocyanate résiduel passe en solution dans l'eau. On centrifuge la suspension ainsi obtenue à 1700 g pendant 20 min et on lave le solide obtenu avec 200 mL d'alcool éthylique. Après centrifugation à 1720 g pendant 20 min et élimination du surnageant éthanolique, on sèche le solide à la température ambiante.

### Analyses

Le spectre de diffraction des rayons X de la poudre obtenue après séchage de la composition de particules montre une structure (Cu₂ZnSnS₄) unique. L'analyse par modélisation selon la méthode de Debye et Scherrer montre des domaines organisés cristallins dont la taille apparente moyenne est de l'ordre de 60 nm.

On réalise un broyage des particules comme décrit précédemment à l'exemple 1 et on sélectionne les particules par centrifugation à 1720 g pendant 10 min. On collecte et on sèche le surnageant pour former une poudre de particules solides.

L'analyse de cette poudre de particules solides par microscopie électronique à transmission montre une composition de particules submicroniques individualisées dont le diamètre apparent moyen est de l'ordre de 150 nm.

L'analyse des données spectrales obtenues par spectroscopie d'absorption dans le proche infrarouge indique une largeur de bande interdite de 1,3 eV.

EXEMPLE 6 - Fabrication d'un matériau solide selon l'invention à base de Cu, Zn, Sn, S selon l'invention par traitement solvothermal dans l'éthylène glycol et traitement en sels fondus.

Dans 300 mL d'éthylène glycol, on introduit 2,555 g de chlorure de cuivre(II) (CuCl₂-2H₂O ; 15 mmoles), 1,020 g de chlorure de zinc(II) (ZinCl₂ ; 7,5 mmoles), 2.625 g de chlorure d'étain(IV) hydraté (SnCl₄ 5H₂O ; 7,5 mmoles). On maintient la suspension des sels métalliques ainsi formée sous agitation pendant 10 min jusqu'à complète dissolution desdits sels métalliques dans l'éthylène glycol. On ajoute ensuite à la solution de Sn(IV), Cu(II) et Zn(II), 5,705 g de thio-urée (CS(NH₂)₂ ; 75 mmoles) et on maintient l'agitation de ladite solution pendant 20 min à la température ambiante. On ajoute ensuite sous agitation et à température ambiante 6,075 mL d'une solution de TMaOH dans le méthanol (TMaOH ; 15 mmoles). On laisse le mélange sous agitation pendant 20 min supplémentaires. Les proportions molaires (Cu ; Zn ; Sn ; S ; OH) dans la composition sont (2 ; 1 ; 1 ; 10 ; 2).

On place ce mélange dans un creuset en téflon disposé dans un autoclave (bombe de Parr) à la température de 200°C pendant 16 h. L'autoclave est ensuite refroidit par déclin thermique naturel jusqu'à la température ambiante. On obtient un précipité que l'on sépare de l'éthylène glycol par centrifugation à 1720 g pendant 20 min à la température ambiante. On lave trois fois le précipité avec 300 mL d'eau puis une fois avec 300 mL d'alcool éthylique. On récupère le précipité par centrifugation puis séchage à température ambiante pendant 48 h.

### Broyage du matériau solide dans l'alcool éthylique

On réalise un broyage tel que décrit à l'exemple 4. Après élimination des billes de broyage, on reprend la suspension de broyage dans 600 mL d'alcool éthylique. On élimine la phase éthylique par soutirage et on lave le précipité obtenu trois fois avec 250 mL d'alcool éthylique. On centrifuge la suspension éthylique ainsi obtenue à 500 g pendant 10 min de façon à éliminer par sédimentation les particules de plus grand diamètre. On collecte dans le surnageant les particules fines selon l'invention.

### Analyses

L'analyse d'une fraction aliquote de cette suspension par microscopie électronique à transmission montre des objets individualisés de diamètre équivalent moyen sensiblement de l'ordre de 200 nm et se présentant sous la forme de cristaux élémentaires de diamètres équivalent moyen de l'ordre de 10 nm.

On sèche la suspension de particules par évaporation de l'alcool éthylique de façon à former une poudre finement divisée dont le spectre de diffraction des rayons X montre des domaines organisés dont le diamètre apparent moyen est de l'ordre de 10 nm.

EXEMPLE 7 - Fabrication d'un matériau solide selon l'invention à base de Cu, Zn, Sn, S.

On mélange 0,4 g de la poudre (Cu₂ ; Zn ; Sn ; S₄) obtenue à l'issue du procédé décrit à l'exemple 6 avec 1,3 g de thiocyanate de potassium. La proportion molaire (S)/(Cu) dans le mélange est de 7. Le mélange, placé dans un creuset en alumine, est introduit dans une enceinte sous atmosphère d'azote à la température ambiante. On chauffe l'enceinte de façon que sa température augmente régulièrement et atteigne 400°C en 150 min, puis on maintient cette température de 400°C dans l'enceinte pendant 16 h. Après refroidissement naturel de l'enceinte, on reprend la poudre calcinée dans 300 mL d'eau déminéralisée et on homogénéise la suspension par agitation magnétique pendant 30 min de façon à dissoudre le thiocyanate résiduel dans l'eau. On centrifuge la suspension ainsi obtenue à 1700 g pendant 20 min et on lave le solide obtenu avec 300 mL d'alcool éthylique. Après centrifugation à 1720 g pendant 20 min et élimination du surnageant éthanolique, on sèche le solide à la température ambiante.

### Analyses

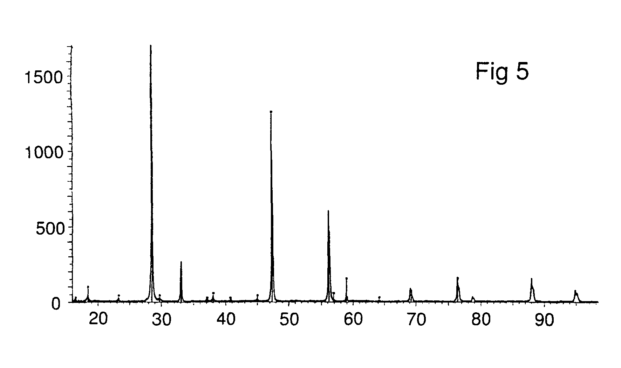

Le spectre de diffraction des rayons X de la poudre (figure 5) obtenue après séchage de la composition de particules montre une structure (Cu₂ZnSnS₄) unique. L'analyse par modélisation selon la méthode de Debye et Scherrer montre des domaines organisés cristallins dont la taille apparente moyenne est de l'ordre de 60 nm.

On réalise un broyage des particules comme décrit précédemment à l'exemple 1 et on sélectionne les particules par centrifugation à 1720 g pendant 10 min. On collecte et on sèche le surnageant pour former une poudre de particules solides.

L'analyse de cette poudre de particules solides par microscopie électronique à transmission montre une composition de particules submicroniques individualisées et cristallisées dont le diamètre apparent moyen est de l'ordre de 200 nm.

L'analyse des données spectrales obtenues par spectroscopie d'absorption dans le proche infrarouge indique une largeur de bande interdite de 0,9 eV.

EXEMPLE 8 - Fabrication d'un matériau solide selon l'invention à base de Cu, Zn, Sn, S selon l'invention par traitement solvothermal dans l'éthylène glycol à partir de sels chlorures métalliques puis traitement en sels fondus.

Dans 200 mL d'éthylène glycol, on introduit 1.73 g de chlorure d'étain(IV) hydraté (SnCl₄ 5H₂O, soit 4.95 mmoles), 0.8 g de chlorure de zinc(II) (ZnCl₂, 5.85 mmoles) et 1,534 g de chlorure de cuivre(II) (CuCl₂-2H₂O, 9 mmoles). On maintient la suspension des sels métalliques ainsi formée sous agitation à température ambiante jusqu'à complète dissolution desdits sels métalliques dans l'éthylène glycol. On ajoute ensuite à la solution de Sn(IV), Cu(II) et Zn(II), 3.42 g de thio-urée CS(NH₂)₂, (FLUKA ALDRICH, France, 45 mmoles) et on maintient l'agitation de ladite solution pendant 10 min à température ambiante. On ajoute ensuite sous agitation et à température ambiante, 3.645 mL d'une solution d'hydroxyde de tétraméthylammonium (TMaOH) à 25 % (soit 9 mM) dans le méthanol MeOH et on laisse sous agitation pendant 30 min. On complète la solution à 300 mL par de l'éthylène glycol et on laisse le mélange sous agitation pendant 20 min supplémentaires. Les proportions molaires (Cu ; Zn ; Sn ; S ; OH) dans la solution sont (2 ; 1,3 ; 1,1 ; 10 ; 2).

On place ce mélange dans un creuset en téflon que l'on dispose dans un autoclave (bombe de Parr) non agité et placé dans une étuve à la température de 200°C pendant 16 h. L'autoclave est ensuite refroidit par déclin thermique naturel jusqu'à la température ambiante.

On obtient un précipité que l'on sépare de la solution liquide des eaux-mères par centrifugation à 1720 g pendant 20 min à la température ambiante. On lave le précipité avec 300 mL d'eau et on récupère le précipité par centrifugation à 1720 g pendant 20 min à la température ambiante. On répète trois fois cette opération de lavage à l'eau du précipité. On rince dans l'alcool éthylique le précipité que l'on récupère par centrifugation.

On reproduit une fois à l'identique la synthèse décrite ci-dessus à l'exemple 8 et on collecte les deux précipités obtenus. Après séchage à température ambiante pendant 48 h, on pèse le précipité (m = 4 g).

### Broyage du matériau solide

On place le précipité obtenu ci-dessus (4 g), 32 g de billes de broyage (granulométrie de l'ordre de 0,3 mm) formées de ZrO₂-Y₂O₃ et 10 mL d'alcool éthylique dans le réceptacle d'un broyeur à attrition. On soumet cette préparation à un traitement broyage pendant une durée de 4 heures à la température ambiante. On rajoute 10 mL d'alcool éthylique et on poursuit le broyage pendant une durée supplémentaire de 4 heures. On place la suspension du solide broyé sous agitation pendant 12 heures en présence des billes de broyage, puis on sépare par filtration les billes de broyage et la suspension dudit matériau solide.

On réalise une pluralité de lavages des billes de broyage dans l'alcool éthylique et on sépare par filtration les billes de broyage et les suspensions de lavage du matériau solide. On regroupe les suspensions contenant le matériau solide obtenues par lavages successifs des billes de broyage pour former une suspension du matériau solide dans l'alcool éthylique.

On réalise une centrifugation de cette suspension à 2080 g pendant 20 min, lors de laquelle on sépare un culot solide brut comprenant le matériau solide et un surnageant liquide qui est éliminé.

On reprend et on suspend le culot solide brut obtenu dans 600 mL d'alcool éthylique, on traite la suspension alternativement par les ultrasons et par agitation magnétique et on centrifuge celle-ci à 1470 g pendant 10 min. On obtient culot résiduel et un surnageant coloré (marron/noir) formé d'une suspension du matériau solide selon l'invention dans l'alcool éthylique. On répète deux fois successivement l'opération de lavage du culot résiduel.

On mélange les trois suspensions du matériau solide (volume total 1800 mL) dans l'alcool éthylique. La concentration du matériau solide à l'état divisé Cu₂ZnSnS₄ dans la suspension est de 0,8 g/L. La suspension stockée en flacons étanches est stable vis à vis de la décantation sur plus de 4 jours.

On réalise une analyse de la suspension en microscopie électronique à transmission après traitement de ladite suspension aux ultrasons, dépôt et séchage sur une membrane, lors de laquelle on visualise des nanoparticules individualisées de taille de l'ordre de 180 nm sous forme d'agrégats. Ces agrégats sont constitués de cristallites primaires de taille de l'ordre de 7 nm.

L'analyse par diffraction des rayons X des nanoparticules de la suspension montre un ensemble de raies attribuables à la structure Cu₂ZnSnS₄.

Les particules du matériau solide dispersé dans une résine est analysé par spectroscopie de dispersion d'énergie sous microscope électronique (grossissement de x2000) à balayage (EDS-MEB) sur 5 champs d'observation statistiquement représentatifs. Les rapports molaires Zn/Cu = 1 et Sn/Cu = 1 mesurés démontrent la composition stoechiométrique du matériau.

### Traitement thermique en sels fondus

On mélange 0,5 g de la poudre de particules (Cu₂ ; Zn ; Sn ; S₄) obtenue ci-dessus avec 1,66 g de KSCN. La proportion molaire (S)/(Cu) dans le mélange est de 7,5. Le mélange, placé dans un creuset en alumine, est introduit dans une enceinte sous atmosphère d'azote à la température ambiante. On chauffe l'enceinte de façon que sa température augmente régulièrement et atteigne 500°C en 150 min, puis on maintient cette température de 500°C dans l'enceinte pendant 6 h. Après refroidissement naturel de l'enceinte, on reprend la poudre calcinée dans 200 mL d'eau déminéralisée et on homogénéise la suspension par agitation magnétique pendant 30 min de façon que le KSCN résiduel passe en solution dans l'eau. On centrifuge la suspension ainsi obtenue à 1700 g pendant 20 min, on élimine le surnageant et on reprend le solide obtenu avec 200 mL d'eau déminéralisée par homogénéisation pendant 20 min. On forme une suspension (S1).

On centrifuge la suspension (S1) obtenue à 1720 g pendant 20 min de façon à former un culot solide (C1) et une dispersion (D1) colorée qui est soumise à une centrifugation à 8000 g pendant 20 min. Le culot (C2) de centrifugation à 8000 g est dispersé dans 20 mL d'alcool éthylique pour former une dispersion (D1) du matériau solide selon l'invention dans l'alcool éthylique,

On reprend et on disperse le culot solide (C1) dans 200 mL d'alcool éthylique par agitation magnétique pendant 20 min pour former une suspension (S2). Par centrifugation de la suspension (S2) à 1720 g pendant 20 min, on forme une dispersion (D2) colorée qui est soumise à une étape de centrifugation à 8000 g pendant 20 min. Le culot (C3) de centrifugation à 8000 g est dispersé dans 20 mL d'alcool éthylique pour former une dispersion (D3) du matériau solide selon l'invention dans l'alcool éthylique. On mélange les dispersions (D2) et (D3). Les particules du matériau solide obtenu forment une dispersion stable sur plusieurs jours dans l'alcool éthylique.

L'analyse par microscopie électronique à transmission de (D2) et (D3) montre des particules parfaitement individualisées, de taille de l'ordre de 100 nm et présentant une morphologie de type plaquettaire et/ou cubique.

L'analyse de la dispersion (D2) et (D3) après séchage par diffraction des rayons X montre des raies attribuables à Cu₂ZnSnS₄.

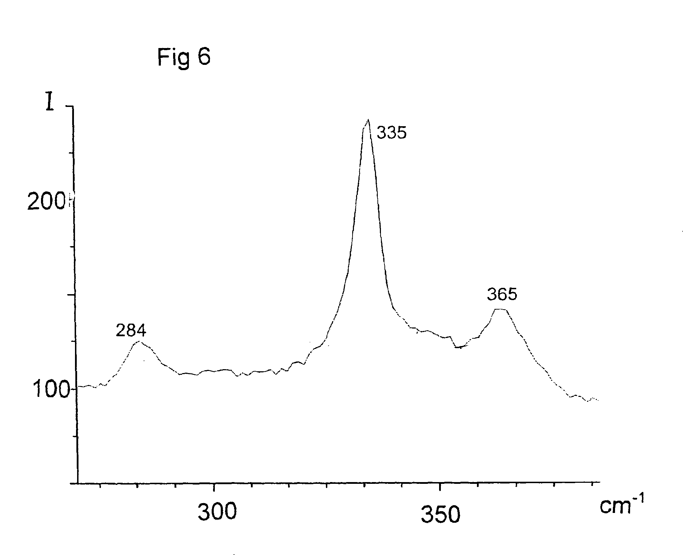

Le spectre Raman des particules des dispersions (D2) et (D3) représenté en figure 6 présente, dans la région 200-400 cm⁻¹, une raie principale centrée à 335 cm⁻¹ et des raies secondaires centrées à 365 et 284 cm⁻¹.

EXEMPLE 9 - Fabrication d'un matériau solide selon l'invention à base de Cu, Zn, Sn, S selon l'invention par traitement solvothermal dans l'isopropanol à partir de sels chlorures métalliques et traitement en sels fondus.

Dans 200 mL d'isopropanol absolu, on introduit 1,534 g de chlorure de cuivre(II) (CuCl₂-2H₂O, 9 mmoles), 1.577 g de chlorure d'étain(IV) hydraté (SnCl₄ 5H₂O, soit 6.75 mmoles) et 0.922 g de chlorure de zinc(II) (ZnCl₂, 5.85 mmoles). On maintient le mélange des sels métalliques dans l'isopropanol sous agitation à température ambiante pendant une durée de l'ordre de 20 min et jusqu'à dissolution desdits sels dans l'isopropanol. On ajoute ensuite à la solution de Sn(IV), Cu(II) et Zn(II), 4,793 g de thio-urée CS(NH₂)₂, (FLUKA ALDRICH, France, 63 mmoles) et on maintient l'agitation de ladite solution pendant 10 min à température ambiante. On ajoute ensuite sous agitation et à température ambiante, 7,29 mL d'une solution d'hydroxyde de tétraméthylammonium (TMaOH) à 25 % (soit 18 mM) dans le méthanol et on laisse sous agitation pendant 30 min.

On complète la solution avec 1,584 g d'acide ascorbique (C₆H₈O₆, ALDRICH, France, 9 mmoles). On complète la solution à 240 mL par de l'isopropanol absolu et on laisse le mélange sous agitation pendant 20 min supplémentaires. Les proportions molaires (Cu ; Zn ; Sn ; S ; OH ; Ac. Ascorbique) dans la solution sont (2 ; 1,5 ; 1 ; 14 ; 4 ; 2).

On traite cette solution dans un autoclave comme décrit à l'exemple 8. L'autoclave est ensuite refroidit par déclin thermique naturel jusqu'à la température ambiante.

On obtient un précipité que l'on sépare de la solution liquide des eaux-mères par centrifugation à 1720 g pendant 20 min à la température ambiante. On lave le précipité avec 240 mL d'eau et on récupère le précipité par centrifugation à 1720 g pendant 20 min à la température ambiante. On répète trois fois cette opération de lavage à l'eau du précipité. On rince dans l'alcool éthylique le précipité que l'on récupère par centrifugation.

On reproduit une fois à l'identique la synthèse décrite ci-dessus à l'exemple 8 et on collecte les deux précipités obtenus. Après séchage à température ambiante pendant 48 h, on pèse le précipité (m = 4 g).

L'étape de broyage du matériau solide est réalisée selon le procédé de broyage décrit à l'exemple 8. La concentration du matériau solide à l'état divisé Cu₂ZnSnS₄ dans la suspension finale est de 0,8 g/L. La suspension stockée en flacons étanches est stable vis à vis de la décantation sur plus de 4 jours.

L'analyse de la suspension en microscopie électronique à transmission après traitement de ladite suspension aux ultrasons, dépôt et séchage sur une membrane, montre des nanoparticules individualisées de taille de l'ordre de 150 nm sous forme d'agrégats. Ces agrégats sont constitués de cristallites primaires de taille de l'ordre de 6 nm. L'analyse par diffraction des rayons X des nanoparticules de la suspension montre un ensemble de raies attribuables à la structure Cu₂ZnSnS₄.

L'analyse des nanoparticules par spectroscopie de dispersion d'énergie sous microscope électronique (grossissement de x2000) à balayage (EDS-MEB) sur 5 champs d'observation statistiquement représentatifs montre que le rapport molaire Zn/Cu = 0,85 et Sn/Cu = 1,13.

### Traitement thermique en sels fondus

On mélange 0,5 g de la poudre de particules (Cu₂ ; Zn ; Sn ; S₄) obtenue ci-dessus avec 2,49 g de KSCN solide. La proportion molaire (S)/(Cu) dans le mélange est de 11,25. Le mélange, placé dans un creuset en alumine, est introduit dans une enceinte sous atmosphère d'azote à la température ambiante. On chauffe l'enceinte de façon que sa température augmente régulièrement et atteigne 450°C en 150 min, puis on maintient cette température de 450°C dans l'enceinte pendant 6 h. Après refroidissement naturel de l'enceinte, on procède conformément au procédé décrit à l'exemple 8.

L'analyse par microscopie électronique à transmission de (D2) et (D3) montre des particules parfaitement individualisées, de taille de l'ordre de 150 nm et présentant une morphologie de type plaquettaire et/ou cubique.

L'analyse de la dispersion (D2) et (D3) après séchage par diffraction des rayons X montre des raies attribuables à Cu₂ZnSnS₄. Les particules du matériau solide obtenu forment une dispersion stable sur plusieurs jours dans l'alcool éthylique

## Revendications

1. Matériau (1) solide de formule (A) suivante :
(Cu⁺¹*ₐ₋ᵤ* ; Ag⁺¹*ᵤ* ; Zn⁺²_{*b-v-(y*/*2)*} ; Cd⁺*²ᵥ* ; Sn⁺⁴_{*c-w(y*/*2)*} ; *¹X*⁺*⁴_{w}* ; *²X*⁺*³_{y}* ; S⁻²*_{d-x}* ; Se⁻²*ₓ*) (A), où ; *a, b, c*, *d, u, v, w, x, y* et leur combinaisons arithmétiques sont des nombres réels qui représentent la fraction atomique de chaque élément auquel chaque nombre est associé dans la formule (A), et tels que :
○ 1,6 < *a* < 2,4 ;
○ 0,6 < *b* < 1,2 ;
○ 0,6 < *c* < 1,2 ;
○ 3,5 < *d* < 4,5, et ;
○ *u, v*, *w, x* et *y* appartiennent indépendamment les uns des autres à l'ensemble des nombres réels appartenant à l'intervalle [0 ; 0,5[, et ;
■ *¹X*^{+*4*} est choisi dans le groupe formé des cations du titane (Ti), des cations du zirconium (Zr) et des cations du plomb (Pb),
■ *²X*^{+*3*} est choisi dans le groupe formé des cations du gallium (Ga), des cations de l'indium (In) et des cations de l'yttrium,
ledit matériau (1) solide :
- est à l'état divisé sous la forme de particules présentant un diamètre équivalent moyen compris entre 15 nm et 400 nm, et,
- présente, par analyse dudit matériau (1) solide par diffraction des rayons X, une structure cristalline unique, et ;
- est adapté pour pouvoir former une dispersion stable d'au moins un matériau solide de formule (A) dans un liquide, dit liquide de dispersion, formé d'au moins un composé présentant une valeur de δ_{P} supérieure à 8 et une valeur de δ_{H} supérieure à 5.

2. Matériau (1) selon la revendication 1, **caractérisé en ce que** le liquide de dispersion est choisi dans le groupe formé de l'alcool éthylique, de l'acétonitrile, de l'éthylène glycol, du diméthylsulfoxyde, du propylène glycol, du méthanol et du diméthylformamide.

3. Matériau (1) selon l'une des revendications 1 ou 2, **caractérisé en ce qu'**il présente, en spectroscopie d'absorption, une largeur de bande interdite comprise entre 0,9 eV et 2,8 eV.

4. Matériau (1) selon l'une des revendications 1 à 3, **caractérisé en ce que** les particules constitutives du matériau (1) solide présentent au moins un domaine, dit domaine cristallin, de taille moyenne, mesurée par diffraction des rayons X, comprise entre 4 nm et 100 nm, ledit domaine cristallin présentant la structure cristalline unique.

5. Matériau (1) selon l'une des revendications 1 à 4, **caractérisé en ce qu'**il est formé de particules poly-cristallines.

6. Matériau (1) selon l'une des revendications 1 à 4, **caractérisé en ce que** les particules constitutives du matériau solide de formule (A) sont des particules monocristallines.

7. Matériau (1) selon l'une des revendications 1 à 6, **caractérisé en ce qu'**il présente, par spectroscopie Raman, une raie de diffusion, dite raie primaire, présentant une intensité maximum de diffusion à une valeur de nombre d'onde comprise entre 310 cm⁻¹ et 340 cm⁻¹.

8. Matériau (1) selon la revendication 7, **caractérisé en ce que** la raie primaire présente une largeur de raie à mi-hauteur comprise entre 5 cm⁻¹ et 60 cm⁻¹.

9. Matériau (1) selon la revendication 6, **caractérisé en ce qu'**il présente, par spectroscopie Raman, une raie de diffusion, dite raie primaire, présentant une intensité maximum de diffusion à une valeur de nombre d'onde comprise entre 330 cm⁻¹ et 340 cm⁻¹.

10. Matériau (1) selon la revendication 9, **caractérisé en ce que** ladite raie primaire présente une largeur de raie à mi-hauteur comprise entre 5 cm⁻¹ et 18 cm⁻¹.

11. Matériau (1) selon l'une des revendications 1 à 10, **caractérisé en ce qu'**il présente, par spectroscopie Raman, une raie de diffusion secondaire, présentant une intensité maximum de diffusion à une valeur de nombre d'onde comprise entre 260 cm⁻¹ et 285 cm⁻¹.

12. Procédé d'obtention d'un matériau (1) solide de formule (A) selon l'une des revendications 1 à 11, comprenant les étapes suivantes :
- (a) on choisit au moins un composé précurseur de chaque élément constitutif du matériau (1) solide de formule (A) ;
- (b) on prépare une composition, dite composition (15) de précurseurs, solide par mélange (2) du(des) précurseur(s) de chaque élément constitutif du matériau (1) solide de formule (A), puis ;
- (c) on place cette composition (15) de précurseurs dans une enceinte sous atmosphère d'un gaz inerte à une température de l'ordre de la température ambiante ;
- (d) on chauffe la composition (15) de précurseurs lors d'une étape, dite étape (3) en sels fondus, selon un taux d'accroissement de la température compris entre 0,5°C/min et 10,0°C/min et adapté pour que la température de l'enceinte atteigne une température de synthèse, comprise entre 250°C et 500°C, et on maintient ladite température de synthèse pendant une durée, dite durée de synthèse, comprise entre 2 h et 36 h de façon à former un matériau (16) recristallisé présentant une structure unique par diffraction des rayons X, puis,
- (e) on réalise, après refroidissement du matériau (16) recristallisé, un traitement (4) de séparation d'un matériau (17) solide exempt de précurseurs,
- (f) ultérieurement à ces étapes (a) à (e), on soumet le matériau (17) solide exempt de précurseurs à une étape (5) de réduction de sa granulométrie, puis,
- (g) on réalise une étape (6) de sélection des particules du matériau (18) de granulométrie ainsi réduite adaptée pour conserver les particules de granulométrie la plus faible.

13. Procédé selon la revendication 12, **caractérisé en ce que** :
- les proportions molaires (*a'*, *u'*, *b'*, *v'*, *c'*, *y'* et *w'*) respectives des éléments Cu, Ag, Zn, Cd, Sn, *¹X*, *²X* constitutifs de la composition (15) de précurseurs sont dans les proportions stoechiométriques *a, u, b, v, c*, *y* et *w* respectives du matériau (1) solide de formule (A) ;
- les proportions molaires (*d' et x'*) respectives des éléments S et Se des sels constitutifs de la composition (15) de précurseurs sont telles que la somme (*d'* + *x'*) est comprise entre 5 et 30,
- lesdites valeurs (*a', u'*, *b', v', c', y', w', d' et x'*) étant adaptées pour satisfaire la condition d'électro-neutralité du matériau (1) solide.

14. Procédé selon l'une des revendications 12 ou 13, **caractérisé en ce qu'**on choisit :
- le(s) précurseur(s) de cuivre (Cu) dans le groupe formé du chlorure cuivreux (CuCl), du chlorure cuivrique di-hydraté (CuCl₂ 2H₂O), du nitrate de cuivre (Cu(NO₃)₂), de l'acétate de cuivre (CH₃COO)₂Cu), des hydroxydes de Cu fraichement préparés et des (oxy)hydroxydes de Cu fraichement préparés ;
- le(s) précurseur(s) d'étain (Sn) dans le groupe formé du chlorure stannique penta-hydrate (SnCl₄ 5H₂O), de l'acétate stannique (CH₃COO)₄Sn), des hydroxydes de Sn⁺⁴ fraichement préparés et des (oxy)hydroxydes de Sn⁺⁴ fraichement préparés ;
- le(s) précurseur(s) de zinc (Zn) dans le groupe formé du chlorure de zinc (ZnCl₂), de l'acétate de zinc (CH₃COO)₂Zn), des hydroxydes de Zn⁺² fraichement préparés et des (oxy)hydroxydes de Zn⁺² fraichement préparés ;
- le(s) précurseurs(s) d'anion(s) dans le groupe formé du thiocyanate de potassium (K-S-C≡N), de la thio-urée (S=C(NH₂)₂) du sulfure de sodium hydraté (Na₂S, 9H₂O), du sulfure de sodium (Na₂S) et de la séléno-urée (Se=C(NH₂)₂),
- le(s) précurseurs(s) de dopant(s) dans le groupe formé du nitrate d'argent (AgNO₃), du chlorure de gallium (GaCl₃), du chlorure de cadmium (CdCl₂), du nitrate de gallium (Ga(NO₃)₃), du nitrate de cadmium (Cd(NO₃)₃), de l'iodure de cadmium (CdI₂) et de l'acétate de plomb (CH₃COO)₄Pb), du nitrate d'yttrium (Y(NO₃)₃), des (oxy)hydroxydes de gallium, des (oxy)hydroxydes de plomb et des (oxy)hydroxydes d'yttrium.

15. Procédé selon l'une des revendications 12 à 14, **caractérisé en ce qu'**on soumet directement la composition (15) de précurseurs à l'étape (3) en sels fondus.

16. Procédé selon l'une des revendications 12 à 14, **caractérisé en ce qu'**après l'étape (a) ;
- on prépare une solution, dite solution (22) de précurseurs, par mélange (21) du(des) précurseur(s) de chaque élément constitutif du matériau (1) solide de formule (A) dans un milieu, dit milieu (20) solvant, liquide comprenant au moins un composé liquide choisi dans le groupe formé de l'éthylène glycol, de l'acétonitrile et des alcools, puis ;
- on réalise un traitement, dit traitement (23) solvothermal, de ladite solution (22) de précurseurs dans un réacteur clos à une température comprise entre 140°C et 250°C pendant une durée comprise entre 8 h et 24 h, puis,
- on réalise une étape (25) de séparation solide/liquide d'un résidu (24) solide formé lors du traitement (23) solvothermal dans ladite solution (22) de précurseurs, puis,
- on réalise un broyage (26) dudit solide (24) de façon à former une poudre (27) finement divisée, puis,
- on soumet la poudre (27) finement divisée à l'étape (3) en sels fondus.

17. Procédé selon l'une des revendications 12 à 16, **caractérisé en ce que**, lors de l'étape (3) en sels fondus, le taux d'accroissement de la température de ladite enceinte est compris entre 1°C/min et 2°C/min et la température de synthèse est comprise entre 350°C et 460°C.

18. Procédé selon l'une des revendications 12 à 17, **caractérisé en ce que** le gaz inerte est choisi dans le groupe formé de l'argon (Ar) et de l'azote moléculaire (N₂).

19. Utilisation d'un matériau (1) solide selon l'une des revendications 1 à 11, dans laquelle on réalise une dispersion dudit matériau (1) solide dans un milieu liquide, dit liquide de dispersion, formé d'au moins un composé présentant une valeur de δ_{P} supérieure à 8 et une valeur de δ_{H} supérieure à 5.

20. Utilisation d'un matériau (1) solide selon la revendication 19 pour la fabrication d'un film photo-absorbant d'une cellule photovoltaïque.

21. Utilisation d'un matériau (1) solide selon la revendication 19 pour la fabrication d'un film photo-catalytique.

22. Utilisation selon l'une des revendications 20 ou 21 d'un matériau (1) solide selon l'une des revendications 1 à 11, dans laquelle on réalise une dispersion dudit matériau (1) solide de formule (A) dans un milieu liquide, dit liquide de dispersion, et on applique ladite dispersion sur une surface solide de façon à former un film de ladite dispersion de particules d'épaisseur comprise entre 0,1 µm et 5 µm.

## Patentansprüche

1. Festmaterial (1) mit der folgenden Formel (A):
(Cu⁺¹*ₐ₋ᵤ* ; Ag⁺¹*ᵤ* ; Zn⁺²_{*b-v-(y*/*2)*} ; Cd⁺*²ᵥ* ; Sn⁺⁴_{*c-w-(y*/*2)*} ; *¹X*⁺*⁴_{w}* ; *²X*⁺³*_{y}* ; S⁻²*_{d-x}* ; Se⁻²*ₓ*) (A),
wobei
*a, b, c*, *d*, *u, v, w, x, y* und ihre arithmetischen Kombinationen reelle Zahlen sind, die den Atomanteil jedes Elements darstellen, mit dem jede Anzahl in der Formel (A) assoziiert ist, und so dass
- 1,6 < a < 2,4 ;
- 0,6 < b < 1,2 ;
- 0,6 < *c* < 1,2 ;
- 3,5 < *d* < 4,5, und ;
- *u, v, w, x* und *y* unabhängig voneinander der Gesamtheit der reellen Zahlen angehören, die Teil des Intervalls [0; 0,5[ sind; und;
- ¹X⁺⁴ ausgewählt ist aus der Gruppe gebildet von Titankationen (Ti), Zirkoniumkationen (Zr) und Bleikationen (Pb),
- ²X⁺³ ausgewählt ist aus der Gruppe gebildet von Galliumkationen (Ga), Indiumkationen (In) und Yttriumkationen,
wobei das Festmaterial (1):
- im geteilten Zustand in der Form von Partikeln vorliegt, die einen mittleren äquivalenten Durchmesser zwischen 15 nm und 400 nm aufweist, und
- durch Analyse des Festmaterials (1) durch Röntgendiffraktion eine einzigartige kristalline Struktur aufweist, und
- ausgelegt ist, um eine stabile Dispersion von mindestens einem Festmaterial mit der Formel (A) in einer Flüssigkeit zu bilden, genannt Dispersionsflüssigkeit, gebildet aus mindestens einer Verbindung, die einen Wert von δ_{P} aufweist, der größer als 8 ist, und einen Wert von δ_{H}, der größer als 5 ist.

2. Material (1) nach Anspruch 1, **dadurch gekennzeichnet, dass** die Dispersionsflüssigkeit ausgewählt ist aus der Gruppe, gebildet aus Ethylalkohol, Azetonitril, Methylenglykol, Dimethylsulfoxid, Propylenglykol, Methanol und Dimethylformamid.

3. Material (1) nach einem der Ansprüche 1 oder 2, **dadurch gekennzeichnet, dass** es in der Absorptionsspektroskopie eine Breite des Bandabstands zwischen 0,9 eV und 2,8 eV aufweist.

4. Material (1) nach einem der Ansprüche 1 bis 3, **dadurch gekennzeichnet, dass** die konstitutiven Partikel des Festmaterials (1) mindestens einen Bereich darstellen, genannt kristalliner Bereich, von mittlerer Größe, gemessen durch Röntgendiffraktion, der zwischen 4 nm und 100 nm liegt, wobei der kristalline Bereich die einzigartige kristalline Struktur aufweist.

5. Material (1) nach einem der Ansprüche 1 bis 4, **dadurch gekennzeichnet, dass** es aus polykristallinen Partikeln gebildet ist.

6. Material (1) nach einem der Ansprüche 1 bis 4, **dadurch gekennzeichnet, dass** die konstitutiven Partikel des Festmaterials mit der Formel (A) monokristalline Partikel sind.

7. Material (1) nach einem der Ansprüche 1 bis 6, **dadurch gekennzeichnet, dass** es, durch Ramanspektroskopie, eine Diffusionslinie, genannt primäre Linie, aufweist, die eine maximale Diffusionsintensität mit einem Wellenzahlwert zwischen 310 cm⁻¹ und 340 cm⁻¹ aufweist.

8. Material (1) nach Anspruch 7, **dadurch gekennzeichnet, dass** die primäre Linie eine Linienbreite in halber Höhe zwischen 5 cm⁻¹ und 60 cm⁻¹ aufweist.

9. Material (1) nach Anspruch 6, **dadurch gekennzeichnet, dass** es, durch Ramanspektroskopie, eine Diffusionslinie, genannt primäre Linie, aufweist, die eine maximale Diffusionsintensität mit einem Wellenzahlwert zwischen 330 cm⁻¹ und 340 cm⁻¹ aufweist.

10. Material (1) nach Anspruch 9, **dadurch gekennzeichnet, dass** die primäre Linie eine Linienbreite in halber Höhe zwischen 5 cm⁻¹ und 18 cm⁻¹aufweist.

11. Material (1) nach einem der Ansprüche 1 bis 10, **dadurch gekennzeichnet, dass** es, durch Ramanspektroskopie, eine sekundäre Diffusionslinie aufweist, die eine maximale Diffusionsintensität mit einem Wellenzahlwert zwischen 260 cm⁻¹ und 285 cm⁻¹ aufweist.

12. Verfahren zum Erhalt eines Festmaterials (1) mit der Formel (A) nach einem der Ansprüche 1 bis 11, umfassend die folgenden Schritte:
- (a) Auswählen von mindestens einer Vorläuferverbindung jedes konstitutiven Elements des Festmaterials (1) mit der Formel (A);
- (b) Zubereiten einer festen Zusammensetzung, genannt Vorläuferzusammensetzung (15), durch Mischung (2) des Vorläufers/der Vorläufer jedes konstitutiven Elements des Festmaterials (1) mit der Formel (A), dann;
- (c) Anordnen dieser Vorläuferzusammensetzung (15) in einem Gehäuse unter der Atmosphäre eines inerten Gases bei einer Temperatur im Bereich der Raumtemperatur;
- (d) Erhitzen der Vorläuferzusammensetzung (15) Vorläufer bei einem Schritt, genannt Schritt in flüssigen Salzen (3), gemäß einer Erhöhungsrate der Temperatur zwischen 0,5 °C/min und 10,0 °C/min und dazu ausgelegt, dass die Temperatur des Gehäuses eine Synthesetemperatur erreicht, die zwischen 250 °C und 500 °C liegt, und Beibehalten der Synthesetemperatur während einer Dauer, genannt Synthesedauer, die zwischen 2h und 36 h liegt, um ein rekristallisiertes Material (16), das eine einzigartige Struktur aufweist, durch Röntgendiffraktion zu bilden, dann
- (e) Durchführen, nach dem Abkühlen des rekristallisierten Materials (16), einer Behandlung (4) zur Trennung eines Festmaterials (17), das frei von Vorläufern ist,
- (f) nach diesen Schritten (a) bis (e) Unterziehen des Festmaterials (17), das frei von Vorläufern ist, einem Schritt (5) zur Reduktion seiner Granulometrie, dann,
- (g) Durchführen eines Schritts (6) der Auswahl der Partikel des Materials (18) mit einer derart reduzierten Granulometrie, die ausgelegt ist, um die Partikel mit der kleinsten Granulometrie aufzubewahren.

13. Verfahren nach Anspruch 12, **dadurch gekennzeichnet, dass**:
- die jeweiligen molaren Verhältnisse (*a', u', b', v', c', y'* und *w'*) der Elemente Cu, Ag, Zn, Cd, Sn, ¹X, ²X, konstitutiv für die der Vorläuferzusammensetzung, in den stöchiometrischen Verhältnissen *a, u, b*, *v, c, y* und *w* bzw. des Festmaterials (1) mit der Formel (A) liegen;
- die entsprechenden molaren Verhältnisse (d' und x') der Elemente S und Se der konstitutiven Salze der Vorläuferzusammensetzung (15) derart sind, dass die Summe (d' + x') zwischen 5 und 30 liegt,
- wobei die Werte (*a', u', b', v', c', y', w', d'* und x') ausgelegt sind, um die Bedingung der elektrischen Neutralität des Festmaterials (1) zu erfüllen.

14. Verfahren (1) nach einem der Ansprüche 12 oder 13, **dadurch gekennzeichnet, dass** Folgendes ausgewählt wird:
- der/die Vorläufer von Kupfer (Cu) in der Gruppe, gebildet aus Kupfer(I)chlorid (CuCl), Kupfer(II)chlorid-Dihydrat (CuCl₂ 2H₂O), Kupfernitrat (Cu(NO₃)₂), Kupferazetat (CH₃COO)₂,Cu), frisch zubereitete Kupferhydroxide und frisch zubereitete Kuper(oxy)hydroxide;
- der/die Vorläufer von Zinn (Sn) in der Gruppe, gebildet aus Zinntetrachlorid-Pentahydrat (SnCl₄ 5H₂O), Zinnacetat (CH₃COO)₄Sn), frisch zubereitete Sn⁺⁴-Hydroxide und frisch zubereitete Sn⁺⁴-(oxy)hydroxide;
- der/die Vorläufer von Zink (Zn) in der Gruppe, gebildet aus Zinkchlorid (ZnCl₂), Zinkazetat (CH₃COO)₂Zn), frisch zubereitete Zn⁺²-Hydroxide und frisch zubereitete Zn⁺²-(oxy)hydroxide;
- der/die Vorläufer von Anion(en) in der Gruppe, gebildet aus Kaliumthiocyanat (K-S-C≡N), Thioharnstoff (S=C(NH₂)₂) von hydratisiertem Natriumsulfid (Na₂S, 9H₂O), Natriumsulfid (Na₂S) und Selenharnstoff (Se=C (NH₂)₂),
- der/die Vorläufer von Wirkstoff(en) in der Gruppe, gebildet aus Silbernitrat (AgNO₃), Galliumchlorid (GaCl₃), Cadmiumchlorid (CdCl₂), Galliumnitrat (Ga(NO₃)₃), Cadmiumnitrat Cd(NO₃)₃), Cadmiumiodid (Cdl₂) und Bleiacetat (CH₃COO)₄Pb), Yttriumnitrat (Y(NO₃)₃), Gallium(oxy)hydroxide, Blei(oxy)hydroxide und Yttrium(oxy)hydroxide.

15. Verfahren nach einem der Ansprüche 12 bis 14, **dadurch gekennzeichnet, dass** die Vorläuferzusammensetzung (15) direkt dem Schritt (3) mit flüssigen Salzen unterzogen wird.

16. Verfahren nach einem der Ansprüche 12 bis 14, **dadurch gekennzeichnet, dass** nach dem Schritt (a)
- eine Lösung, genannt Vorläuferlösung (22), durch Mischung (21) des/der Vorläufer(s) jedes konstitutiven Elements des Festmaterials (1) mit der Formel (A) in einem flüssigen Medium, genannt Lösemittelmedium (20), zubereitet wird, umfassend mindestens eine flüssige Verbindung, ausgewählt aus der Gruppe, gebildet aus Ethylenglykol, Azetonitril und Alkoholen, dann
- eine Behandlung, genannt solvothermische Behandlung (23), der Vorläuferlösung (22) in einem geschlossenen Reaktor bei einer Temperatur zwischen 140°C und 250°C während einer Dauer zwischen 8 h und 24 h durchgeführt wird, dann,
- ein Trennungsschritt (25) Feststoff/Flüssigkeit eines festen Rückstands (24), gebildet während der solvothermischen Behandlung (23) in der Vorläuferlösung (22), durchgeführt wird, dann
- eine Zerkleinerung (26) des Feststoffs (24) durchgeführt wird, um ein fein zerteiltes Pulver (27) zu bilden, dann
- das fein zerteilte Pulver (27) dem Schritt mit flüssigen Salzen (3) unterzogen wird.

17. Verfahren nach einem der Ansprüche 12 bis 16, **dadurch gekennzeichnet, dass** während des Schritts (3) mit flüssigen Salzen die Erhöhungsrate der Temperatur des Gehäuses zwischen 1 °C/min und 2 °C/min liegt und die Synthesetemperatur zwischen 350 °C und 460 °C liegt.

18. Verfahren nach einem der Ansprüche 12 bis 17, **dadurch gekennzeichnet, dass** das inerte Gas ausgewählt ist aus der Gruppe gebildet aus Argon (Ar) und Molekularstickstoff (N₂).

19. Verwendung eines Festmaterials (1) nach einem der Ansprüche 1 bis 11, wobei eine Dispersion des Festmaterials (1) in einem flüssigen Medium, genannt Dispersionsmedium, durchgeführt wird, gebildet aus mindestens einer Verbindung, die einen Wert von δ_{P} aufweist, der größer als 8 ist, und einen Wert von δ_{H}, der größer als 5 ist.

20. Verwendung eines Festmaterials (1) nach Anspruch 19 für die Herstellung einer lichtabsorbierenden Folie einer photovoltaischen Zelle.

21. Verwendung eines Festmaterials (1) nach Anspruch 19 für die Herstellung einer lichtkatalytischen Folie.

22. Verwendung nach einem der Ansprüche 20 oder 21 eines Festmaterials (1) nach einem der Ansprüche 1 bis 11, wobei eine Dispersion des Festmaterials (1) mit der Formel (A) in einem flüssigen Medium, genannt Dispersionsmedium, durchgeführt wird, und die Dispersion auf eine feste Oberfläche aufgebracht wird, um eine Folie der genannten Dispersion von Partikeln mit einer Dicke zwischen 0,1 µm und 5 µm zu bilden.

## Claims

1. A solid material (1) of the following formula (A):
(Cu⁺¹*ₐ₋ᵤ*; Ag⁺¹*ᵤ*; Zn⁺²_{*b-v-(y*/*2)*}; Cd⁺²*ᵥ*; Sn⁺⁴_{*c-w-(y*/*2)*}; *¹X*⁺⁴*_{w}*; *²X*⁺³*_{y}*; S⁻²*_{d-x}*; Se⁻²*ₓ*) (A), wherein:
*a, b, c, d, u, v, w, x, y* and their arithmetic combinations are real numbers which represent the atomic fraction of each element with which each number is associated in formula (A) and are such that:
○ 1.6 < *a* < 2.4;
○ 0.6 < *b* < 1.2;
○ 0.6 < *c* < 1.2;
○ 3.5 < *d* < 4.5 and;
○ *u, v, w*, *x* and *y*, independently of one another, belong to the set of real numbers belonging to the interval [0; 0.5[, and,
■ *¹X*^{+*4*} is chosen from the group formed of the cations of titanium (Ti), the cations of zirconium (Zr) and the cations of lead (Pb),
■ *²X*^{+*3*} is chosen from the group formed of the cations of gallium (Ga), the cations of indium (In) and the cations of yttrium;
said solid material (1):
- is in the divided state in the form of particles having a mean equivalent diameter of from 15 nm to 400 nm, and
- exhibits, by analysis of said solid material (1) by X-ray diffraction, a single crystal structure, and;
- is adapted to be able to form a stable dispersion of at least one solid material of formula (A) in a liquid, called the dispersion liquid, formed of at least one compound having a δ_{P} value greater than 8 and a δ_{H} value greater than 5.

2. The material (1) as claimed in claim 1, wherein the dispersion liquid is chosen from the group formed of ethyl alcohol, acetonitrile, ethylene glycol, dimethyl sulfoxide, propylene glycol, methanol and dimethylformamide.

3. The material (1) as claimed in either claim 1 or claim 2, wherein it has, in absorption spectroscopy, a forbidden band width of from 0.9 eV to 2.8 eV.

4. The material (1) as claimed in any one of claims 1 to 3, wherein the particles constituting the solid material (1) have at least one domain, called the crystal domain, having a mean size, measured by X-ray diffraction, of from 4 nm to 100 nm, said crystal domain having the single crystal structure.

5. The material (1) as claimed in any one of claims 1 to 4, wherein it is formed of polycrystalline particles.

6. The material (1) as claimed in any one of claims 1 to 4, wherein the particles constituting the solid material of formula (A) are monocrystalline particles.

7. The material (1) as claimed in any one of claims 1 to 6, wherein it has, by Raman spectroscopy, a scattering line, called the primary line, which has a maximum scattering intensity at a wave number value of from 310 cm⁻¹ to 340 cm⁻¹.

8. The material (1) as claimed in claim 7, wherein the primary line has a line width at half-height of from 5 cm⁻¹ to 60 cm⁻¹.

9. The material (1) as claimed in claim 6, wherein it has, by Raman spectroscopy, a scattering line, called the primary line, which has a maximum scattering intensity at a wave number value of from 330 cm⁻¹ to 340 cm⁻¹.

10. The material (1) as claimed in claim 9, wherein said primary line has a line width at half-height of from 5 cm⁻¹ to 18 cm⁻¹.

11. The material (1) as claimed in any one of claims 1 to 10, wherein it has, by Raman spectroscopy, a secondary scattering line which has a maximum scattering intensity at a wave number value of from 260 cm⁻¹ to 285 cm⁻¹.

12. A process for obtaining a solid material (1) of formula (A) according to any one of claims 1 to 11, comprising the following steps:
- (a) at least one precursor compound of each element constituting the solid material (1) of formula (A) is chosen;
- (b) a solid composition, called the composition (15) of precursors, is prepared by mixing (2) the precursor(s) of each element constituting the solid material (1) of formula (A), and then;
- (c) the composition (15) of precursors is placed in a vessel under an inert gas atmosphere at a temperature of approximately ambient temperature;
- (d) the composition (15) of precursors is heated during a step, called the molten salt step (3), at a rate of increase of the temperature which is from 0.5°C/minute to 10.0°C/minute and which is adapted so that the temperature of the vessel reaches a synthesis temperature of from 250°C to 500°C, and said synthesis temperature is maintained for a period, called the synthesis period, of from 2 hours to 36 hours so as to form a recrystallized material (16) having a single structure by X-ray diffraction; and then;
- (e) after cooling of the recrystallized material (16), a treatment (4) of separation of a solid material (17) that is free of precursors is carried out;
- (f) following steps (a) to (e), the solid material (17) free of precursors is subjected to a step (5) of reduction of its particle size, and then,
- (g) there is carried out a step (6) of selection of the particles of the material (18) whose particle size has been so reduced, adapted to retain the particles having the smallest particle size.

13. The process as claimed in claim 12, wherein:
- the respective molar proportions (*a', u', b', v', c', y'* and *w'*) of the elements Cu, Ag, Zn, Cd, Sn, *¹X, ²X* constituting the composition (15) of precursors are in the respective stoichiometric proportions *a, u, b, v*, *c, y* and *w* of the solid material (1) of formula (A),
- the respective molar proportions (*d'* and *x'*) of the elements S and Se of the salts constituting the composition (15) of precursors are such that the sum (*d'* + *x'*) is from 5 to 30,
- said values (*a', u', b', v', c', y', w', d'* and *x'*) being adapted to satisfy the condition of electroneutrality of the solid material (1).

14. The process as claimed in either claim 12 or claim 13, wherein:
- the precursor(s) of copper (Cu) is/are chosen from the group formed of copper chloride (CuCl), copper chloride dihydrate (CuCl₂ 2H₂O), copper nitrate (Cu(NO₃)₂), copper acetate (CH₃COO)₂Cu), freshly prepared Cu hydroxides and freshly prepared Cu (oxy)hydroxides;
- the precursor(s) of tin (Sn) is/are chosen from the group formed of stannic chloride pentahydrate (SnCl₄ 5H₂O), stannic acetate (CH₃COO)₄Sn), freshly prepared Sn⁺⁴ hydroxides and freshly prepared Sn⁺⁴ (oxy)hydroxides;
- the precursor(s) of zinc (Zn) is/are chosen from the group formed of zinc chloride (ZnCl₂), zinc acetate (CH₃COO)₂Zn), freshly prepared Zn⁺² hydroxides and freshly prepared Zn⁺² (oxy)hydroxides;
- the precursor(s) of anion(s) is/are chosen from the group formed of potassium thiocyanate (K-S-C≡N), thiourea (S=C(NH₂)₂), sodium sulfide hydrate (Na₂S, 9H₂O), sodium sulfide (Na₂S) and selenourea (Se=C(NH₂)₂);
- the precursor(s) of doping agent(s) is/are chosen from the group formed of silver nitrate (AgNO₃), gallium chloride (GaCl₃), cadmium chloride (CdCl₂), gallium nitrate (Ga(NO₃)₃), cadmium nitrate (Cd(NO₃)₃), cadmium iodide (CdI₂) and lead acetate (CH₃COO)₄Pb), yttrium nitrate (Y(NO₃)₃), gallium (oxy)hydroxides, lead (oxy)hydroxides and yttrium (oxy)hydroxides.

15. The process as claimed in any one of claims 12 to 14, wherein the composition (15) of precursors is subjected directly to the molten salt step (3).

16. The process as claimed in any one of claims 12 to 14, wherein after step (a):
- a solution, called the solution (22) of precursors, is prepared by mixing (21) the precursor(s) of each element constituting the solid material (1) of formula (A) in a liquid medium, called the solvent medium (20), comprising at least one liquid compound chosen from the group formed of ethylene glycol, acetonitrile and alcohols; and then
- a treatment, called solvothermal treatment (23), of said solution (22) of precursors is carried out in a closed reactor at a temperature of from 140°C to 250°C for a period of from 8 hours to 24 hours, and then,
- a step (25) of solid/liquid separation of a solid residue (24) formed during the solvothermal treatment (23) in said solution (22) of precursors is carried out; and then,
- a grinding (26) of said solid (24) is carried out in order to form a finely divided powder (27), and then,
- the finely divided powder (27) is subjected to the molten salt step (3).

17. The process as claimed in any one of claims 12 to 16, wherein, in the molten salt step (3), the rate of increase of the temperature of said vessel is from 1°C/minute to 2°C/minute and the synthesis temperature is from 350°C to 460°C.

18. The process as claimed in any one of claims 12 to 17, wherein the inert gas is chosen from the group formed of argon (Ar) and molecular nitrogen (N₂).

19. The use of a solid material (1) as claimed in any one of claims 1 to 11, in which there is prepared a dispersion of said solid material (1) in a liquid medium, called the dispersion liquid, formed of at least one compound having a δ_{P} value greater than 8 and a δ_{H} value greater than 5.

20. The use of a solid material (1) as claimed in claim 19 in the production of a photo-absorbing film of a photovoltaic cell.

21. The use of a solid material (1) as claimed in claim 19 in the production of a photocatalytic film.

22. The use as claimed in either claim 20 or claim 21 of a solid material (1) as claimed in any one of claims 1 to 11, wherein there is prepared a dispersion of said solid material (1) of formula (A) in a liquid medium, called the dispersion liquid, and said dispersion is applied to a solid surface in order to form a film of said dispersion of particles having a thickness of from 0.1 µm to 5 µm.
